Europäisches Patentamt

European Patent Office

Office européen des brevets

(11) Publication number: **0 363 495**
**A1**

## EUROPEAN PATENT APPLICATION
## published in accordance with Art. 158(3) EPC

(21) Application number: 89903218.9

(22) Date of filing: 16.03.89

(86) International application number:
PCT/JP89/00283

(87) International publication number:
WO 89/08949 (21.09.89 89/23)

(51) Int. Cl.⁵: **H03H 9/25 , H03H 9/145**

(30) Priority: 17.03.88 JP 617/89
01.09.88 JP 216391/88
14.09.88 JP 228528/88

(43) Date of publication of application:
**18.04.90 Bulletin 90/16**

(84) Designated Contracting States:
**DE FR GB SE**

(71) Applicant: **FUJITSU LIMITED**
**1015, Kamikodanaka Nakahara-ku**
**Kawasaki-shi Kanagawa 211(JP)**

(72) Inventor: **YAMAMOTO Shin-ichi**
**13-35-208, Miyazaki 3-chome Miyamae-ku**
**Kawasaki-shi Kanagawa 213(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **SURFACE ACOUSTIC WAVE DEVICE.**

(57) An IDT electrode (4) is formed on a double-layer structure comprising a diamond crystal layer (2) and a thin AlN film (3) and a third-order Rayleigh or Sezawa wave is caused to propagate along the surface of the double-layer. Alternatively a third-order Rayleigh wave is caused to propagate along the surface of a triple-layer structure comprising a diamond crystal layer (2), a thin AlN film (3) and an $SiO_2$ film provided therebetween. With the aforementioned structure, a SAW device exhibiting a high electromechanical coupling factor and a high phase velocity is available. The SAW device for allowing a third-order Rayleigh wave to propagate along the surface thereof is fit for use as a narrow-band timing extraction filter or a band-pass filter, for use in a microwave region of several to 20 GHz whereas the SAW device for allowing the Sezawa wave to propagate therealong is fit for use as a wide-band voltage control oscillator or a wide-band-pass filter for use in wide range of frequencies covering VHF to UHF bands.

FIG. 22

# DESCRIPTION

## Surface Acoustic Wave Device

### TECHNICAL FIELD

This invention relates to a surface acoustic wave device (SAW device) which employs a piezoelectric thin film, and more particularly to a SAW device which is high in stability and easy to produce for realizing a narrowband timing tank filter or bandpass filter for use in a microwave region of several GHz to 20 GHz or a wideband voltage-controlled oscillator or a wide bandpass filter which is used in a wide frequency range from the VHF-band to the UHF-band.

### BACKGROUND ART

There is a tendency that transinformation content progressively increases as optical communication spreads, and the frequency of transmission signals is being expanded to a microwave region. At present, the development of ultra-high speed optical communication systems of several GHz to 20 GHz-band is in progress. However, since highly stable timing tank filters or bandpass filters for several GHz to 20 GHz-band are necessary to optical repeaters for several GHz to 20 GHz-band, it is a current subject to realize them with SAW devices.

Since generally the finger width d of interdigital transducer electrodes (IDT electrodes) employed in SAW devices and the wave length $\lambda$ of a surface acoustic wave (SAW) have a relationship of $d = \lambda/4$, the phase velocity $V_P$, the frequency f of a propagating SAW and the finger width d of the IDT electrodes have a relationship of $f = V_P/4d$.

When IDT electrodes are to be formed making use of the electron beam or the photo-lithography techniques wherein far-ultraviolet radiation is employed as a light source, since there is a limitation in reduction of the finger width d of IDT electrodes, it is necessary to raise the phase velocity $V_P$ of the SAW in order to realize SAW devices wherein the frequency f ranges from several GHz to 20 GHz.

In recent years, many investigations and many proposals have been made to realize GHz-band SAW filters, however, only 1.8 GHz-band SAW filters have been put into practical use wherein the phase velocity (propagation velocity) $V_P$ of SAWs is about 5,000 m/sec. For such conventional 1.8 GHz-band SAW filter, since the finger width d (d = $\lambda$/4) of IDT electrodes can be about 0.7 $\mu$m, an electrode pattern can be formed using the photo-lithographic techniques wherein far-ultraviolet radiation is employed as a light source.

However, if it is intended to realize, for example, a 7 GHz SAW filter with the structure of such conventional SAW filter, it is necessary to make the finger width d of the IDT electrodes smaller than a minimum value of 0.35 $\mu$m which can be attained by the photo-lithography based on far ultraviolet exposure. Accordingly, it cannot be realized by such technique.

In short, since the minimum finger width d of IDT electrodes which can be realized by the present photo-lithography technique based on far-ultraviolet exposure is about 0.35 $\mu$m, in order to realize a SAW filter for 7 GHz wherein the IDT electrodes can be formed using the above-mentioned technique, it is necessary to make the propagation velocity (phase velocity) $V_P$ of a SAW equal to about 10,000 m/sec at least ($V_P$ = 7 GHz x 4d $\geq$ 9,800 m/sec = 10,000 m/sec).

On the other hand, in order to realize a narrowband SAW filter (loaded $Q_L$ = 1,000) for use as a timing tank filter for 7 GHz-band, it is necessary to set the effective electromechanical coupling coefficient $K^2_{eff}$

of SAWs to a value greater than or equal to 0.1 %, and preferably the effective electromechanical coupling coefficient $K^2_{eff}$ is set to a value greater than or equal to that of SAW in ST cut quartz, that is, is 0.15 % or more ($K^2_{eff} \geqq 0.15$ %).

Meanwhile, if it is considered that a plane (100) or plane (110) Si single-crystal, a plane (100) GaAs single-crystal or the like is used for a substrate of an LSI (large scale integrated circuit), in order to enable SAW devices to be integrated with LSIs therearound, it is necessary to realize the SAW devices constructed directly on a single-crystal semiconductor substrate, for example, a Si single-crystal, a GaAs single-crystal or the like.

However, since a Si single-crystal is a non-piezoelectric crystal of the cubic system and a GaAs single-crystal is a weak piezoelectric crystal of the cubic system, even if IDT electrodes are provided directly on a single-crystal semiconductor substrate, that is, a Si single-crystal or a GaAs single-crystal, the SAW will not be excited or will be excited but very weakly. Therefore, it is desirable to realize a SAW device of a composite substrate structure which includes at least a piezoelectric thin film and a single-crystal semiconductor substrate, that is, a Si single-crystal or a GaAs single-crystal.

Taking a summary of the foregoing aims, the characteristics required for a SAW device with which a narrowband timing tank filter or bandpass filter for use in a microwave region of several GHz to 20 GHz is realized are:

(1) $V_P \geqq 10,000$ m/sec; and

(2) $K^2_{eff} \geqq 0.15$ %.

Further, the requirement in integration of such SAW device with an LSI is that the SAW device has a composite substrate structure which includes at least a single-crystal semiconductor substrate and a piezoelectric thin film.

By the way, in order to realize a wideband voltage controlled oscillator, a wide bandpass filter or the like over a wide frequency range from the VHF-band to the UHF-band using SAW devices, it is necessary to select piezoelectric materials having a high effective electromechanical coupling coefficient $K^2_{eff}$ ($K^2_{eff} \geqq 0.5$ % as an aim).

Meanwhile, in order to produce such SAW devices at a low cost, it is necessary to make it possible to form IDT electrodes by the ordinary photo-lithography technique wherein an ultraviolet exposure device is employed as a light source. To this end, it is necessary for the IDT electrodes to have a finger width d (d = $\lambda/4$) greater than or equal to 1.0 $\mu$m which is a possible minimum value in the case of the ordinary technique. In this instance, in order to realize SAW devices over a wide high frequency range from the VHF-band (100 MHz or so) to the UHF-band (2.0 GHz or so), it is necessary for the SAW to have a propagation velocity (phase velocity) $V_P$ higher than or equal to nearly 8,000 m/sec ($V_P$ = 2.0 GHz x 4d = 8,000 m/sec).

Further, in recent years, as peripheral circuits of such SAW devices are LSIs, it is demanded for SAW devices to be integrated with LSIs.

Taking a summary of the foregoing aims, the characteristics required for SAW devices with which a wideband voltage controlled oscillator, a wide bandpass filter or the like for use over a wide frequency region from the VHF-band to the UHF-band is realized are:

(1) $V_P \geqq 80,000$ m/sec; and

(2) $K^2_{eff} \geqq 0.5$ %.

Further, the requirement in integration of such SAW devices with LSIs is that the SAW device has a composite substrate structure which includes at least a single-crystal semiconductor substrate and a piezoelectric thin film.

Taking such technical background as described above into consideration, it is an object of the present invention to provide SAW devices which are high in stability and easy to produce for realizing narrowband timing tank filters or bandpass filters for use in a microwave region of several GHz to 20 GHz.

It is another object of the present invention to provide SAW devices which are high in stability and easy to produce for realizing wideband voltage-controlled oscillators or wide bandpass filters for use over a wide frequency range from the VHF to the UHF.

DISCLOSURE OF THE INVENTION

When the present invention is considered from a certain aspect, there is provided, as a first basic form of a SAW device of the present invention, a SAW device which comprises a diamond crystal and an aluminum nitride (AlN) thin film formed on the diamond crystal and wherein SAWs propagate on the structure.

Desirably, IDT electrodes are formed on the AlN thin film.

In order to realize a narrowband timing tank filter or bandpass filter for use in a microwave region using a SAW device according to the first basic form of the present invention, the thickness H of the AlN thin film is set to a value which satisfies the expression

$$3.5 \leq kH \leq 5.0$$

where k is a wave number, and among SAWs which propagate on the AlN thin film/diamond crystal, a third Rayleigh wave is utilized.

In this instance, where the diamond crystal is a diamond crystal thin film formed on a single-crystal semiconductor substrate, the thickness D of the diamond crystal thin film and the thickness H of the AlN thin film have the relationship of

$$D \geq 4H$$

In order to realize a wideband voltage-controlled oscillator, a wide bandpass filter or the like using a SAW device according to the first basic form of the present invention, the thickness H of the AlN thin film is set to a value which satisfies the expression

$$1.1 \leq kH \leq 6.0$$

where k is a wave number, and among SAWs which propagate on the AlN thin film/diamond crystal, a Sezawa wave is utilized.

In this instance, where the diamond crystal is a diamond crystal thin film formed on a single-crystal semiconductor substrate, the thickness of the diamond crystal thin film D and the thickness H of the AlN thin film have the relationship of

$$D \geq 5H$$

When the present invention is considered from another certain aspect, a SAW device according to a second basic form of the present invention is constituted such that it comprises a diamond crystal, a silicon dioxide ($SiO_2$) thin film formed on the diamond crystal, and an AlN thin film formed on the $SiO_2$ thin film, and SAWs propagate in a three-layer structure composed of the diamond crystal, $SiO_2$ thin film and AlN thin film.

Desirably, the thickness T of the $SiO_2$ thin film has the following relationship to the thickness H of the AlN thin film:

$$0.01 H \leq T \leq 0.1 H$$

Further, desirably the diamond crystal is a diamond crystal thin film formed on the single-crystal semiconductor substrate.

When IDT electrodes are to be formed on the AlN thin film of a SAW device according to the second basic form of the present invention, the thickness H of the AlN thin film is set to a value which satisfies the expression

$$3.2 \leqq k H \leqq 4.7$$

where k is a wave number, and among SAWs which propagate in the aforementioned three-layer structure, a third Rayleigh wave is utilized.

When IDT electrodes are to be formed on the interface between the AlN thin film and the $SiO_2$ thin film of a SAW device according to the second basic form of the present invention, the thickness H of the AlN thin film is set to a value which satisfies the expression

$$3.7 \leqq k H \leqq 4.7$$

where k is a wave number, and among SAWs which propagate in the three-layer structure, a third Rayleigh wave is utilized.

## BRIEF DESCRIPTION OF THE DRAWINGS

Fig. 1 is a diagrammatic representation showing axes of coordinate system and a two-layer structure composed of a ZnO thin film and a Si single-crystal;

Fig. 2 is a diagram illustrating a kH dependency of the phase velocity of SAWs in a two-layer structure composed of a ZnO thin film and a Si single-crystal;

Fig. 3 is a diagram illustrating a kH dependency of the phase velocity of a SAW in a two-layer structure composed of a plane (0001) AlN thin film and a plane (001) direction [100] Si single-crystal:

Fig. 4 is a diagram illustrating a kH dependency of the phase velocity of a SAW in a two-layer structure composed of a (0001) AlN thin film and a (001) [100] GaAs single-crystal;

Fig. 5 is a diagrammatic representation showing axes of coordinate system and a three-layer structure composed of a single-crystal semiconductor substrate formed from a Si single-crystal, a GaAs single-crystal or the like and two thin film layers;

Fig. 6 is a diagrammatic representation showing axes of coordinate system and a three-layer structure composed of a single-crystal semiconductor substrate formed from a Si single-crystal, a GaAs single-crystal or the like, a diamond crystal thin film and an AlN thin film;

Figs. 7A and 7B are diagrams illustrating relationships between a thickness of a diamond crystal thin film with respect to an AlN thin film and a penetration depth of a SAW;

Fig. 8 is a diagram illustrating a kH dependency of the phase velocity of SAWs in a two-layer structure composed of a (0001) AlN thin film and a (001) [100] diamond crystal thin film;

Figs. 9 and 10 are diagrams illustrating kH dependencies of the effective electromechanical coupling coefficients $K^2_{eff}$ for a first Rayleigh wave in a two-layer structure composed of a (0001) AlN thin film and a (001) [100] diamond crystal thin film;

Fig. 11 is a diagram illustrating a depth dependency of the relative displacement amplitudes for a first Rayleigh wave in a two-layer structure composed of a (0001) AlN thin film and a (001) [100] diamond crystal thin film;

Figs. 12 and 13 are diagrams illustrating kH dependencies of the effective electromechanical coupling coefficients $K^2_{eff}$ of a third Rayleigh wave in a two-layer structure composed of a (0001) AlN thin film and a (001) [100] diamond crystal thin film;

Fig. 14 is a diagram illustrating a depth dependency of the relative amplitude of vertical displacement component for a third Rayleigh wave in a two-layer structure composed of a (0001) AlN thin film and a (001) [100] diamond crystal thin film when kH is set to 1.8, 3.0, 4.0 and 6.0;

Fig. 15 is a diagram illustrating a depth dependency of the relative amplitude of longitudinal displacement component for a third Rayleigh wave in a two-layer structure composed of a (0001) AlN thin film and a (001) [100] diamond crystal thin film when kH is set to 1.8, 3.0, 4.0 and 6.0;

Fig. 16 is a diagram illustrating a depth dependency of the relative potential for a third Rayleigh wave in a two-layer structure composed of a (0001) AlN thin film and a (001) [100] diamond crystal thin film;

Figs. 17 and 18 are diagrams illustrating kH dependencies of the effective electromechanical coupling coefficients $K^2_{eff}$ for a Sezawa wave in a two-layer structure composed of a (0001) AlN thin film and a (001) [100] diamond crystal thin film;

Figs. 19 to 21 are diagrams illustrating depth dependencies of the relative displacement amplitudes for a Sezawa wave in a two-layer structure composed of a (0001) AlN thin film and a (001) [100] diamond single-crystal thin film when kH is set to 1.5, 2.0, and 3.0;

Fig. 22 is a vertical section of a SAW device showing a desirable embodiment for the first basic form of the present invention;

Fig. 23 is cross section of the SAW device shown in Fig. 22;

Fig. 24 is a vertical section of a SAW device showing another desirable embodiment for the first basic form of the present invention;

Fig. 25A is a schematic illustration showing an applicational example of the SAW device shown in Figs. 22 and 23;

Fig. 25B is a schematic perspective section of the SAW device near an IDT electrode shown in Fig. 25A;

Figs. 26 and 27 are schematic views illustrating relationships between velocities of thickness shear wave for each layer in three-layer structures;

Fig. 28 is a schematic view showing a basic construction of a SAW device according to a second basic form of the present invention;

Fig. 29 is a diagram illustrating velocity dispersion characteristics for a third Rayleigh wave;

Fig. 30 is a diagram illustrating a rate of the phase velocity variation for a third Rayleigh wave versus a thickness parameter $\xi$ of a $SiO_2$ thin film;

Fig. 31 is a partial section of a SAW device showing a desirable embodiment for the second basic form of the present invention;

Fig. 32 is a partial section of a SAW device showing another desirable embodiment for the second basic form of the present invention;

Fig. 33 is a diagram illustrating a kH dependency of the effective electromechanical coupling coefficients $K^2_{eff}$ of a third Rayleigh wave in the three-layer structure of Fig. 31; and

Fig. 34 is a diagram illustrating a kH dependency of the effective electromechanical coupling coefficients $K^2_{eff}$ of a third Rayleigh wave in the three-layer structure of Fig. 32.

BEST_MODE_FOR_CARRYING_OUT_THE_INVENTION

In the following, embodiments of the present invention and reasons why the embodiments are reached will be described in detail with reference to the drawings.

A ZnO thin film, an AlN thin film or the like is commonly used as a material of piezoelectric thin film. A ZnO thin film has been an object of investigation from early on. Thus, a two-layer structure composed of a ZnO thin film and a Si single-crystal is examined here.

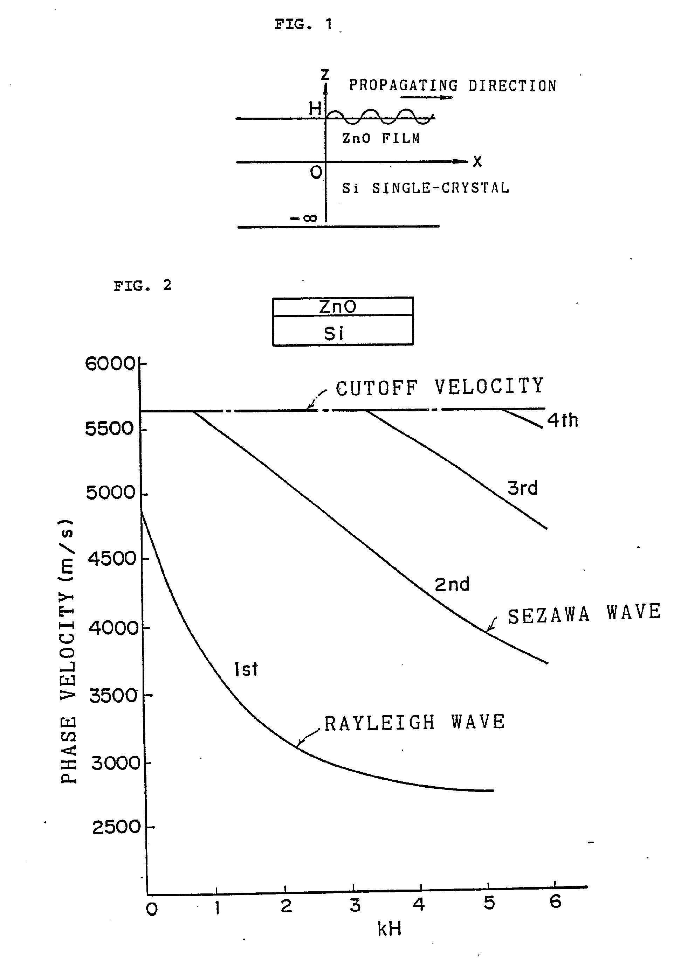

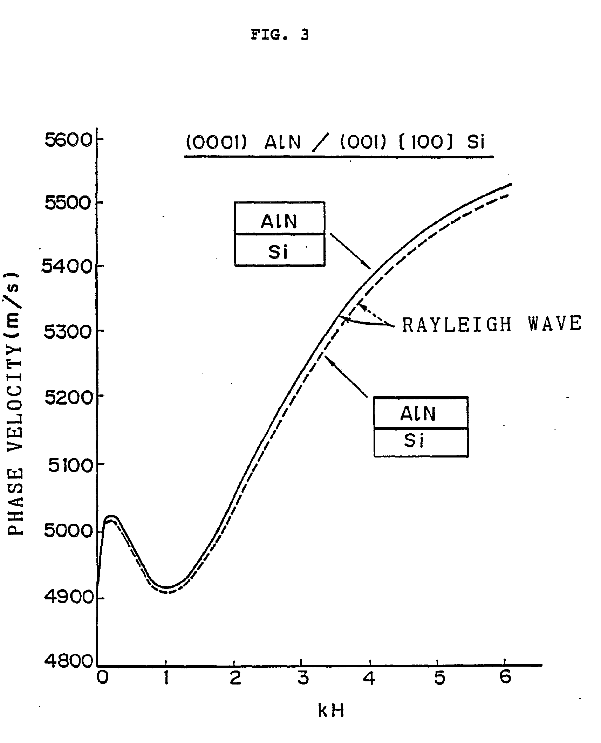

Fig. 1 shows axes of coordinates and a two-layer structure composed of a ZnO thin film and a Si single-crystal, and Fig. 2 is a diagram showing results of analysis of dispersion characteristics for SAWs in the structure of Fig. 1. A dependency of the propagation velocity (phase velocity) $V_p$ of a SAW upon the product kH of a wave number k of a SAW (Rayleigh wave and Sezawa wave) and a thickness H of a ZnO thin film can be seen from Fig. 2.

In order to grow a ZnO thin film in the C-axis direction by sputtering, it is necessary for a SAW device to actually have a three-layer structure composed of a ZnO thin film, a $SiO_2$ thin film and a Si single-crystal. However, since such $SiO_2$ has a sufficiently small thickness, it does not have a significant influence on the SAW characteristics. Accordingly, there is no essential difference even if dispersion characteristics of SAWs in a two-layer structure composed of a ZnO thin film and a Si single-crystal are analyzed.

As can be seen from Fig. 2, whichever of a Rayleigh wave and a Sezawa wave is used, the phase velocity $V_p$ remains within the range of $2,700 \text{ m/sec} \leqq V_p \leqq 5,500 \text{ m/sec}$. Consequently, the aims of the present embodiment cannot be attained. This arises from the fact that the phase velocity of a bulk thickness shear wave in only ZnO is about 2,700 m/sec and low. Therefore, it is not desirable to employ a ZnO thin film.

Meanwhile, an AlN thin film is inferior in regard to the piezoelectricity. However, it has such a high performance that the phase velocity $V_P$ of a SAW therein is about 5,600 m/sec and the phase velocity $V_P$ of a bulk thickness shear wave is about 6,000 m/sec. Accordingly, such AlN thin film is hopeful.

Thus, a two-layer structure composed of an AlN thin film and a Si single-crystal is examined here. Fig. 3 is a diagram showing dispersion characteristics of a SAW in a two-layer structure composed of an AlN thin film and a Si single-crystal. The relationship between the axes of coordinates and the two-layer structure composed of an AlN thin film and a Si single-crystal is similar to that in Fig. 1.

It can be seen from Fig. 3 that the phase velocity $V_P$ in a two-layer structure composed of an AlN thin film and a Si single-crystal remains within the range of 4,900 m/sec < $V_P$ < 5,600 m/sec, and accordingly, it is still impossible to attain the aims of the present invention. This is because the phase velocity $V_P$ of a bulk thickness shear wave in the Si single-crystal used as a substrate is slow at about 5,840 m/sec ($V_P$ = 4,910 m/sec with a Rayleigh wave) and besides the phase velocity $V_P$ of a Rayleigh wave in the AlN thin film itself is low.

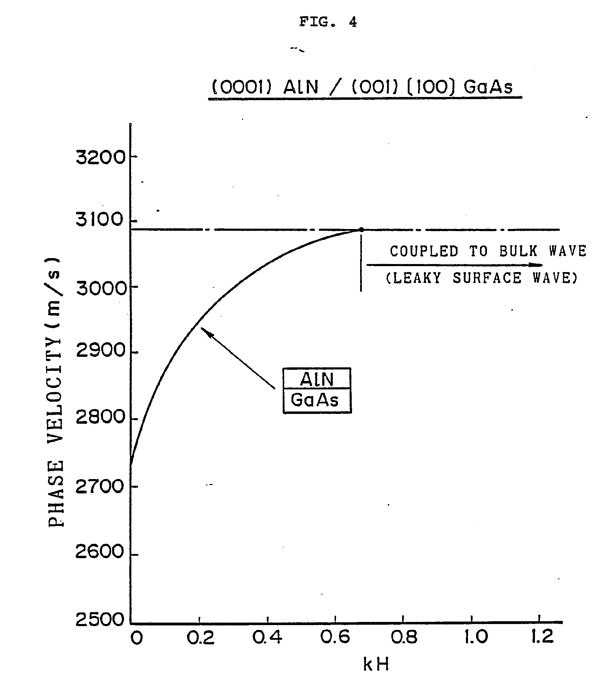

A similar problem takes place where a GaAs single-crystal belonging to the cubic system is employed. Fig. 4 is a diagram showing a dispersion characteristic of a SAW in a two-layer structure composed of an AlN thin film and a GaAs single-crystal. As can be seen from Fig. 4, the phase velocity $V_P$ remains within the range of 2,700 m/sec < $V_P$ < 3,100 m/sec, and at a higher velocity (about 3,086 m/sec), a SAW will be coupled to bulk waves in the GaAs single-crystal to make a leaky surface wave.

It can be seen from the foregoing results of analysis that a Si single-crystal or a GaAs single-crystal is unsuitable as an elastic material. Therefore, it is desirable that a SAW is prevented from penetrating into a Si single-crystal or a GaAs single-crystal.

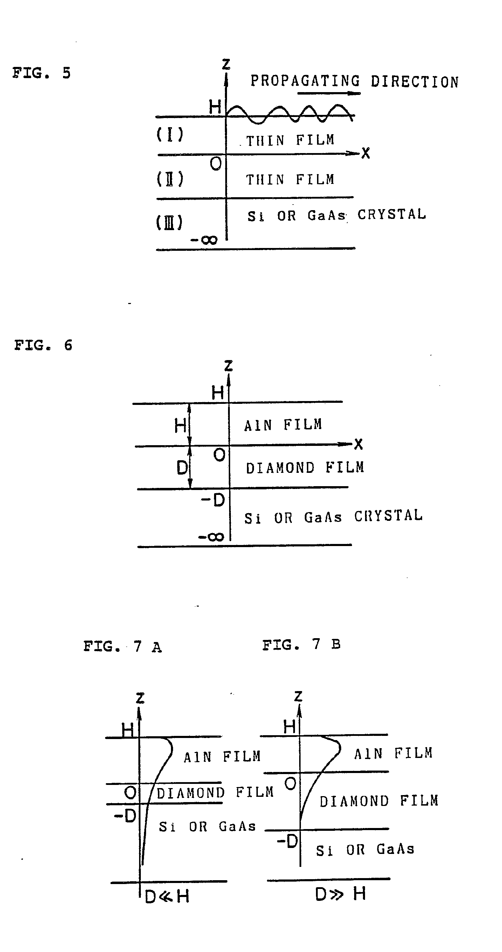

Thus, a SAW device of a three-layer structure shown in Fig. 5 will be examined wherein a SAW is enclosed only in two layers of an upper layer I and an intermediate layer II. The upper layer I is an AlN thin

film orientated to the C-axis. Such AlN thin film orientated to the C-axis can be formed by a PVD method such as magnetron sputtering or the like or a CVD method. If the phase velocities of a Rayleigh wave and a bulk shear wave in the upper layer I are represented by $V_{1R}$ and $V_{1S}$ and the phase velocities of a Rayleigh wave and a bulk thickness shear wave in the intermediate layer II are represented by $V_{2R}$ and $V_{2S}$, respectively, then it is perceived that, when the relationship of $V_{1R} < V_{1S} << V_{2R} < V_{2S}$ stands, a third Rayleigh wave which velocity is higher than that of a first Rayleigh wave is excited in addition to a first Rayleigh wave. Further, notice is taken of a diamond single-crystal thin film or a diamond polycrystal thin film as the intermediate layer II. A diamond single-crystal or polycrystal thin film can be formed synthetically on a single-crystal semiconductor substrate or a glass substrate by a CVD method using methane gas and hydrogen gas ($CH_4 + H_2$) or by a PVD method by ion beam sputtering or the like. Such diamond crystal thin films have such a high performance that the phase velocity $V_p$ of a Rayleigh wave therein is about 11,500 m/sec and the phase velocity $V_p$ of a bulk thickness shear wave is about 12,800 m/sec.

Therefore, in the first basic form of the present invention, a two-layer structure composed of a diamond crystal and an AlN thin film, or desirably a three-layer structure composed of a single-crystal semiconductor substrate of a Si single-crystal, a GaAs single-crystal or the like, a diamond crystal thin film and an AlN thin film, is employed.

Fig. 6 shows axes of coordinates and a three-layer structure composed of a single-crystal (Si or GaAs), a diamond crystal thin film and an AlN thin film. In the three-layer composite structure, where the thickness of the diamond crystal thin film is represented by D and the thickness of the AlN thin film is represented by H, if the thickness D of the diamond crystal thin film is D << H compared with the thickness H of the AlN thin film as shown in Fig. 7A, then a SAW will penetrate into Si or GaAs crystal and be coupled strongly to bulk waves in Si or GaAs. Accordingly, $V_p = 10,000$ m/sec which is one of the aimed values cannot be realized.

On the other hand, if H << D is established as shown in Fig. 7B, then a SAW will be enclosed only in the two-layer films, the diamond crystal thin film and the AlN thin film. Accordingly, an ultra high speed SAW having a phase velocity higher than 10,000 m/sec can be realized.

Thus, at first, SAWs which propagate in a two-layer structure composed of a diamond crystal thin film and an AlN thin film such that the diamond crystal thin film is formed with a sufficiently great thickness (H << D) will be analyzed.

It is assumed that a SAW propagates in parallel to a surface of a substrate, that is, in the [100] direction. An analysis can be made by a large computer applying boundary conditions of individual boundary surfaces to a field equation.

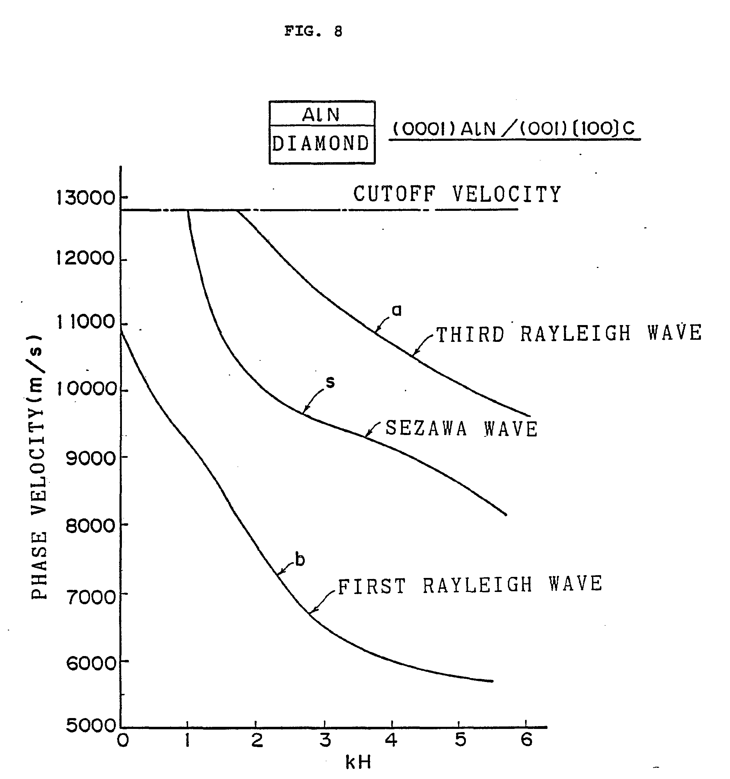

Fig. 8 is a diagram showing results of analysis of SAW dispersion characteristics versus the product kH of a thickness H of the AlN thin film in the two-layer structure composed of the diamond crystal thin film and the AlN thin film and a wave number k of a SAW.

In Fig. 8, the curve b shows a fundamental Rayleigh wave mode. The first Rayleigh wave behaves like a symmetrical Lamb wave in the AlN thin film. On the other hand, the curve a shows a third Rayleigh wave mode and is excited at kH $\geq$ 1.7.

Within the range of kH $\leq$ 6, Rayleigh modes equal to the fifth degree or more and higher degree Sezawa modes are coupled to bulk waves in the diamond crystal thin film to make leaky surface waves.

At first, an investigation is made of conditions required for SAW devices which are high in stability and easy to produce for realizing narrowband timing tank filters or bandpass filters for use in a microwave region of several GHz to 20 GHz in the first basic form of the present invention. The conditions are:

$$V_P \geqq 10,000 \text{ m/sec};$$

and

$$K^2_{eff} \geqq 0.15 \text{ \%}$$

From Fig. 8, the condition for satisfying $V_P \geqq 10,000$ m/sec is $0 \leqq kH \leqq 0.4$ where a first Rayleigh wave is used, but $1.7 < kH \leqq 5.0$ where a third Rayleigh wave is used.

Thus, at first, an examination is made of the case wherein a first Rayleigh wave is used, and an investigation is made of the possibility of realization of the aimed value ($K^2_{eff} \geqq 0.15$) of the effective electromechanical coupling coefficient $K^2_{eff}$ for satisfying the condition of a loaded $Q_L = 1,000$.

When the kH dependency of the effective electromechanical coupling coefficient $K^2_{eff}$ of a first Rayleigh wave is examined, four configurations of electrodes are available. In particular, the first configuration is a construction wherein IDT electrodes are provided on the interface between a diamond single-crystal thin film and an AlN thin film; the second configuration is a construction wherein IDT electrodes are formed on an AlN thin film; the third configuration is a construction wherein IDT electrodes are provided on the interface between a diamond crystal thin film and an AlN thin film, and a grounded electrode is provided on the AlN thin film; and the fourth configuration is a construction wherein IDT electrodes are provided on an AlN thin film and a grounded electrode is provided on interface between a diamond crystal thin film and the AlN thin film.

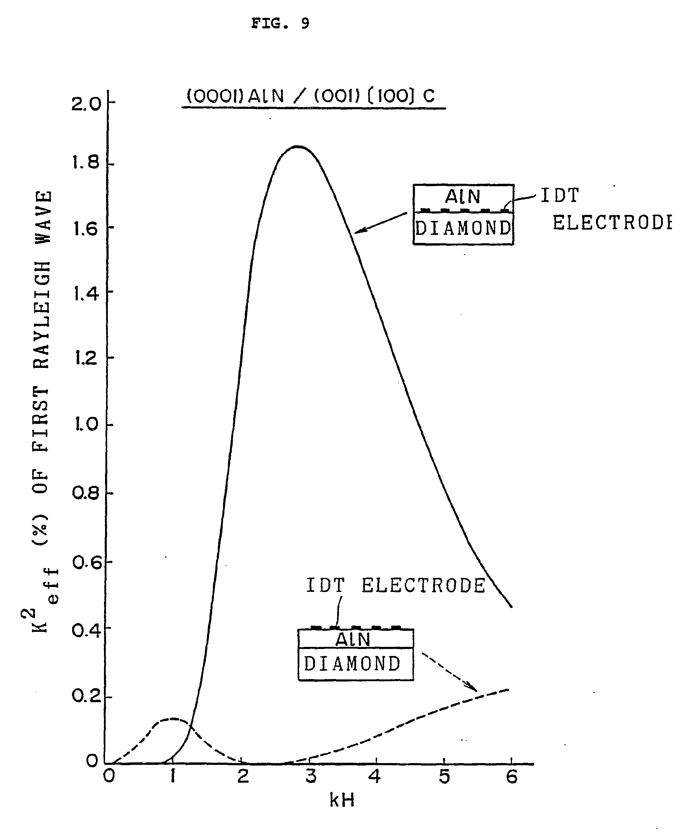

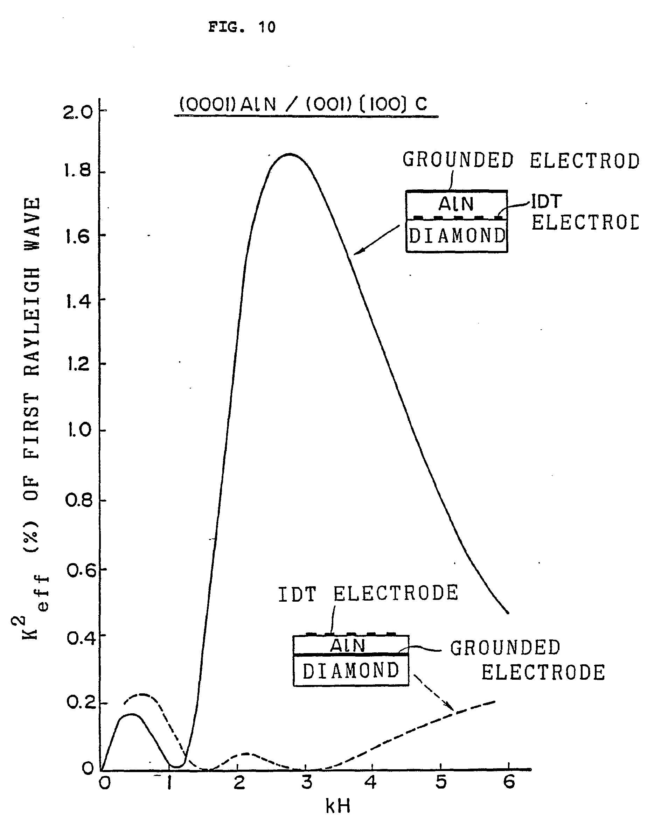

Figs. 9 and 10 are diagrams showing results of analysis of a kH dependency of the effective electromechanical coupling coefficients $K^2_{eff}$ for a first Rayleigh wave where the four electrode configurations described above are adopted. The effective electromechanical coupling coefficient $K^2_{eff}$ makes a barometer regarding an intensity with which a SAW can be excited piezoelectrically.

In order to meet the condition of a loaded $Q_L = 1,000$ to make a narrowband SAW filter, it is necessary to set the effective electromechanical

coupling coefficient $K^2_{eff}$ to a value equal to or greater than 0.15 %. Accordingly, in order to satisfy the condition of $0 \leq kH \leq 0.4$ described above, in the case of the IDT electrode configuration shown in Fig. 10, kH comes to a value within the very limited range from 0.3 to 0.4, and it is difficult to control the film thickness to a value within such range.

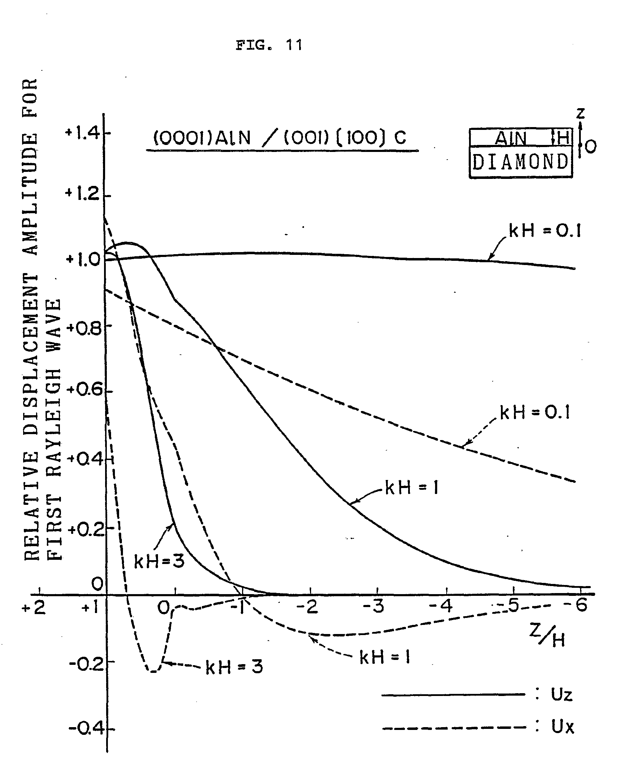

Further, Fig. 11 is a diagram showing results of analysis of a depth (Z-axis direction) dependency of the relative displacement amplitude for a first Rayleigh wave. In Fig. 11, the axis of abscissa represents a value Z/H obtained by dividing the distance in the Z-axis direction from an interface between a diamond crystal thin film and an AlN thin film by the thickness H of the AlN thin film, while the axis of ordinate represents a relative displacement amplitude value for a first Rayleigh wave. In Fig. 11, each solid line curve represents a relative amplitude value $U_Z$ regarding a Z-axis component, while each broken line curve represents a relative amplitude value $U_X$ of an X-axis component.

As can be seen from Fig. 11, in the case of $kH \leq 0.4$, a first Rayleigh wave penetrates deeply into a diamond crystal thin film. Accordingly, in order to enclose a first Rayleigh wave only in the two layers of the diamond crystal thin film and the AlN thin film, it is necessary for the thickness D of the diamond crystal thin film to be much greater than 6 times the thickness H of the AlN thin film (D >> 6H). This is difficult in production and is not preferable from the point of view of the production process and the cost. Therefore, it is considered difficult to realize the aims of $V_P \geq 10,000$ m/sec and $K^2_{eff} \geq 0.15$ % making use of a first Rayleigh wave.

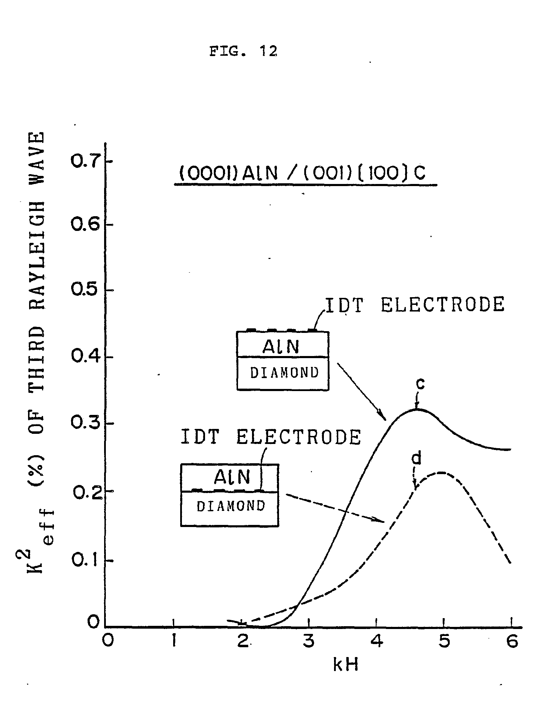

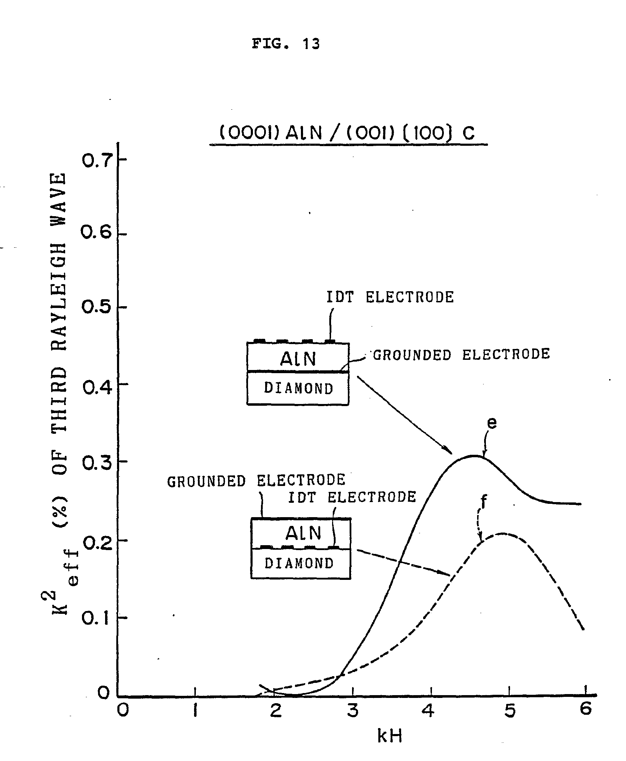

Accordingly, a third Rayleigh wave is used in order to provide a SAW device which is high in stability and easy to produce for realizing a narrowband timing tank filter or bandpass filter for use in a microwave region. Figs. 12 and 13 are diagrams showing results of analysis of a kH dependency of the effective electromechanical coupling coefficients $K^2_{eff}$ where a third Rayleigh wave is used in the four electrode configurations described above.

Referring to Fig. 12, the curve c represents a kH dependency of the effective electromechanical coupling coefficient $K^2_{eff}$ where IDT electrodes are placed on an AlN thin film, while the curve d represents a kH dependency of the effective electromechanical coupling coefficient $K^2_{eff}$ where IDT electrodes are placed on interface between the diamond crystal thin film and the AlN thin film.

On the other hand, referring to Fig. 13, the curve e represents a kH dependency of the effective electromechanical coupling coefficient $K^2_{eff}$ where IDT electrodes are placed on an AlN thin film and a grounded electrode is placed on interface between a diamond crystal thin film and the AlN thin film, while the curve f represents a kH dependency of the effective electromechanical coupling coefficient $K^2_{eff}$ where IDT electrodes are placed on boundary surfaces of a diamond crystal thin film and an AlN thin film and a ground electrode is disposed on the AlN thin film.

As described above, in order to meet the condition of $V_P \geq 10,000$ m/sec using a third Rayleigh wave, it is necessary at least to set the thickness H of an AlN thin film to a value which satisfies the condition of $1.7 < kH \leq 5.0$ (refer to Fig. 8). Accordingly, from Figs. 12 and 13, in order to meet the conditions of $V_P \geq 10,000$ m/sec and $K^2_{eff} \geq 0.15$ % using a third Rayleigh wave when IDT electrodes are to be formed on an AlN thin film (in the case of the curves c and e), it is necessary to control the thickness H of the AlN thin film to a value which satisfies the condition of

$3.5 \leqq kH \leqq 5.0$.

Meanwhile, when IDT electrodes are placed on interface between an AlN thin film and a diamond crystal thin film (in the case of the curves d and f), in order to meet the conditions of $V_P \geqq 10,000$ m/sec and $K^2_{eff} \geqq 0.15$ % using a third Rayleigh wave, it is necessary to control the thickness H of the AlN thin film to a value which satisfies the condition of $4.3 \leqq kH \leqq 5.0$. In this manner, when compared with the case wherein IDT electrodes are formed on an AlN thin film, the range within which the thickness of an AlN thin film is controlled is smaller, and accordingly, the control of the thickness of an AlN thin film is difficult.

By the way, in a SAW device which makes use of a third Rayleigh wave, any other mode is also excited so that, for example, a fundamental Rayleigh wave mode (first Rayleigh wave) becomes spurious. While it is impossible to suppress the first Rayleigh wave completely, it is desirable to reduce the excitation intensity to reduce the spurious level as far as possible.

Thus, referring again to Figs. 9 and 10, where IDT electrodes are formed on interface between an AlN thin film and a diamond crystal thin film, in the condition of $4.3 \leqq kH \leqq 5.0$, the effective electromechanical coupling coefficient $K^2_{eff}$ comes within the range of $0.8 \% \leqq K^2_{eff} \leqq 1.0 \%$ and is 4 to 5 times or more the effective electromechanical coupling coefficient $K^2_{eff}$ of a third Rayleigh wave. On the other hand, where IDT electrodes are formed on an AlN thin film, in the condition of $3.5 \leqq kH \leqq 5.0$, the effective electromechanical coupling coefficient $K^2_{eff}$ of a first Rayleigh wave comes within the range of $0.05 \% \leqq K^2_{eff} \leqq 0.15 \%$ and has a substantially similar value to a first Rayleigh wave. Accordingly, in order to suppress the spurious degree of coupling of a first Rayleigh wave, it is necessary to form IDT electrodes on an AlN thin film.

Accordingly, in order to readily realize the aimed value of the phase velocity $V_P$ of a third Rayleigh wave ($V_P \geqq 10,000$ m/sec) and the aimed value of the effective electromechanical coupling coefficient $K^2_{eff}$ ($K^2_{eff} \geqq 0.15 \%$) while suppressing excitation of a spurious first Rayleigh wave in a two-layer structure composed of a diamond crystal and an AlN thin film or in a three-layer structure composed of a Si single-crystal or a GaAs single-crystal, a diamond crystal thin film and an AlN thin film, it is understood that IDT electrodes should be formed on the AlN thin film and the AlN thin film orientated to the C-axis should be formed on the diamond crystal or the diamond crystal thin film by a magnetron sputtering method or the like such that the thickness H of the AlN thin film may meet the condition of $3.5 \leqq kH \leqq 5.0$.

Subsequently, an investigation is made of a thickness D of a diamond crystal thin film which is necessary, where a diamond crystal is in the form of a thin film formed on a single-crystal semiconductor substrate, to enclose a third Rayleigh wave substantially in a two-layer film of the diamond crystal thin film and an AlN thin film.

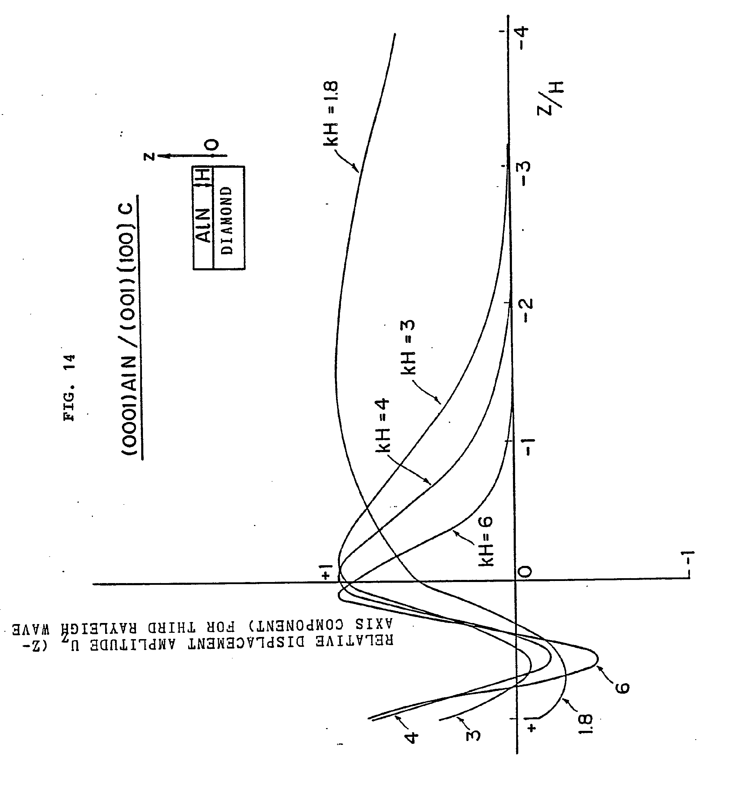

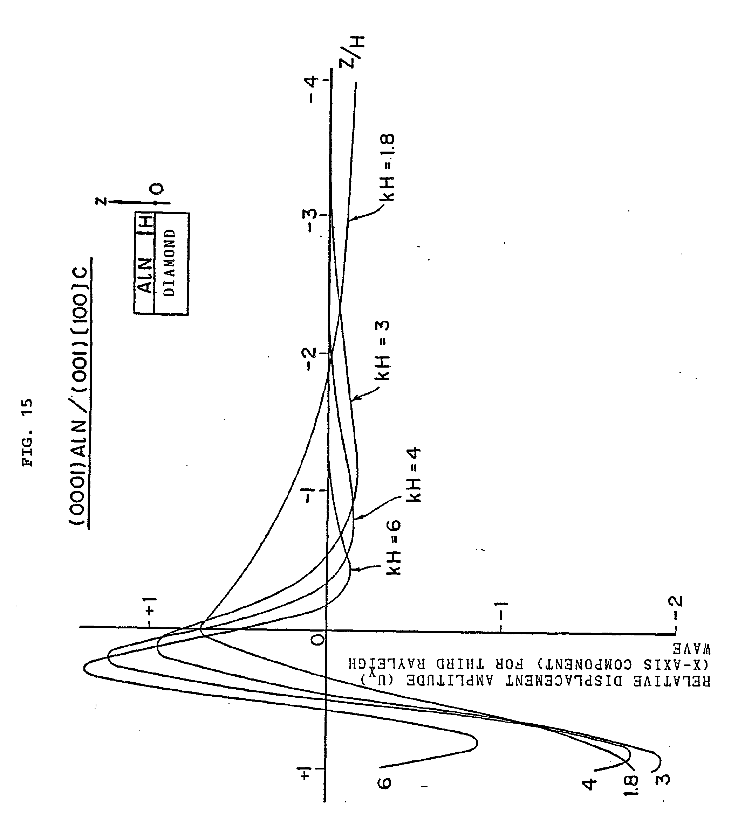

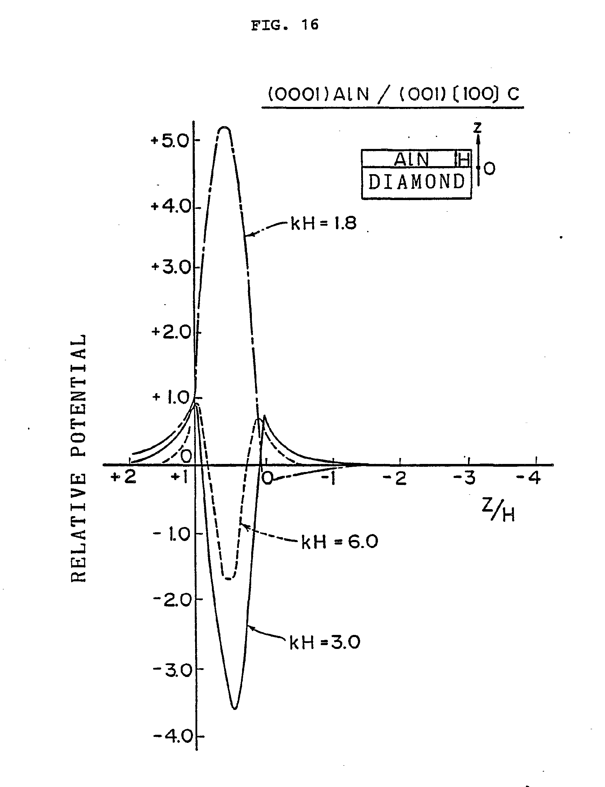

Fig. 14 is a diagram showing results of analysis regarding a depth (Z direction) dependency of the relative displacement amplitude (Z-axis component) $U_Z$ of a SAW when kH is changed to 1.8, 3.0, 4.0 and 6.0, and Fig. 15 is a diagram showing results of analysis regarding a depth dependency (Z direction) of the relative displacement amplitude (X-axis component) $U_X$ of a SAW when kH is changed to 1.8, 3.0, 4.0 and 6.0. In each of the figures, the axis of abscissa indicates a value Z/H obtained by dividing the distance in the Z-axis direction from an interface between a diamond crystal thin film and an AlN thin film by the thickness H of the AlN thin film to normalize the same. It is to be noted that $U_Z$ and $U_X$ are relative values where the absolute value of a maximum amplitude of Z-axis components is made equal to 1. On the other hand, Fig. 16 is a diagram showing results of analysis regarding depth (Z direction) dependency of the relative potential of a SAW when kH is changed to 1.8, 3.0 and 6.0.

It can be seen from the results of analysis shown in Figs. 14 to 16 that the relationship between the thickness D of a diamond crystal thin film and the thickness H of an AlN thin film necessary to enclose a third Rayleigh wave in the two-layer films of the diamond crystal thin film and the AlN thin film should be satisfactorily $D \geqq 4H$.

From the above analysis results, it can be seen that a narrowband SAW filter for 7 GHz which meets the conditions of 10,000 m/sec $\leqq V_P \leqq$ 11,000 m/sec and 0.15 % $\leqq K^2_{eff} \leqq$ 0.3 % can be realized by constituting the same such that it has a basic construction of a three-layer structure composed of a single-crystal semiconductor substrate of a Si single-crystal, a GaAs single-crystal or the like, a diamond crystal thin film and an AlN thin film with IDT electrodes provided on the AlN thin film and the thickness D of the diamond crystal thin film and the thickness H of the AlN thin film are set to values which satisfy the conditions of $D \geq 4H$ and $3.5 \leq kH \leq 5.0$. Besides, as the IDT electrodes are provided on the AlN thin film and the thickness H of the AlN thin film is set to a value which satisfies the condition of $3.5 \leq kH \leq 5.0$, the coupling degree of a spurious first Rayleigh wave can be suppressed. Accordingly, a narrowband SAW filter for 7 GHz which is high in stability can be provided.

Where the SAW device is constructed for 7 GHz, the finger width d of the IDT electrodes can be set to a value of the range of $0.357\,\mu m \leq d \leq 0.393\,\mu m$. Accordingly, the electrode pattern can be formed readily by the photo-lithography technique employing a far-ultraviolet exposure equipment.

Subsequently, description will be given of provision, as another embodiment of the first basic form of the present invention, of a SAW device which is high in stability and easy to produce for realizing a wideband voltage-controlled oscillator or a wide bandpass filter for a wide frequency range from the VHF to the UHF, using a Sezawa wave (denoted at s in Fig. 8). Characteristics required for a SAW device which is high in stability and easy to produce for realizing a wideband voltage-controlled oscillator or a wide bandpass filter are that the phase velocity $V_p$ is a value within the range of

$$V_p \geqq 8,000 \text{ m/sec}$$

and the effective electromechanical coupling coefficient $K^2_{eff}$ is a value within the range of

$$K^2_{eff} \geqq 0.5 \%$$

In order to satisfy the former condition, the thickness H of an AlN thin film should satisfy the following condition

$$1.1 \leqq kH \leqq 6.0$$

as can be seen from Fig. 8. If, for example, kH = 2, then $V_p$ = 10,200 m/sec, and where the finger width d of IDT electrodes is 1.0 $\mu$m, the frequency f = 2.5 GHz ($V_p$ = f x 4d). Thus, a nearly 2.5 GHz SAW device can be realized by the photo-lithography technique employing ultraviolet exposure. On the other hand, if the electrode finger width d is set to d = 0.3 $\mu$m, then a SAW device for f = 8.5 GHz can be realized by the photo-lithography technique employing far-ultraviolet exposure. Further, since the phase velocity $V_p$ is

$V_p$ = 8,050 m/sec even when kH = 6.0, a SAW device for f = 6 to 7 GHz can be realized by the photo-lithography technique employing far-ultraviolet exposure. It can be understood from those facts that a Sezawa wave in a two-layer structure composed of a diamond crystal and an AlN thin film is a hopeful wave from the point of view of the high speed.

Subsequently, an investigation will be made of the possibility of realization of the aimed value ($K^2_{eff} \geq 0.5$ %) of the effective electromechanical coupling coefficient $K^2_{eff}$ regarding a Sezawa wave.

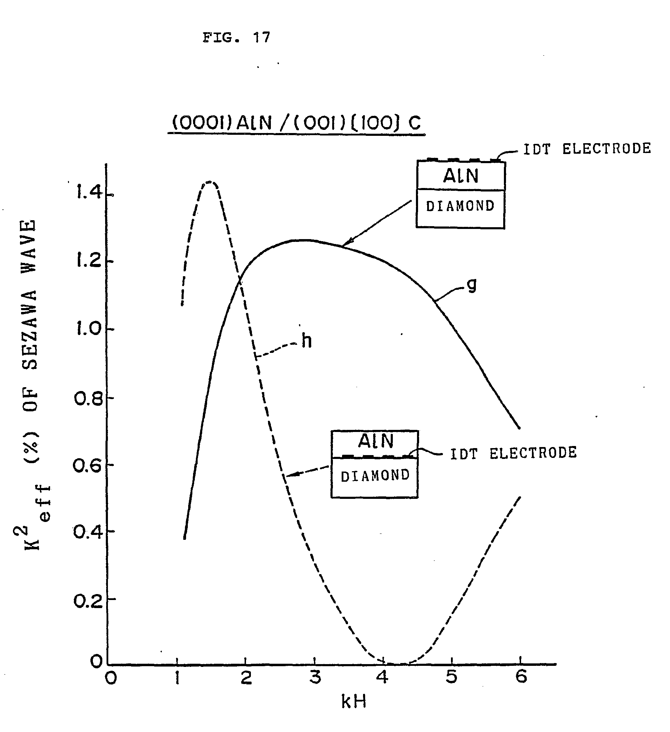

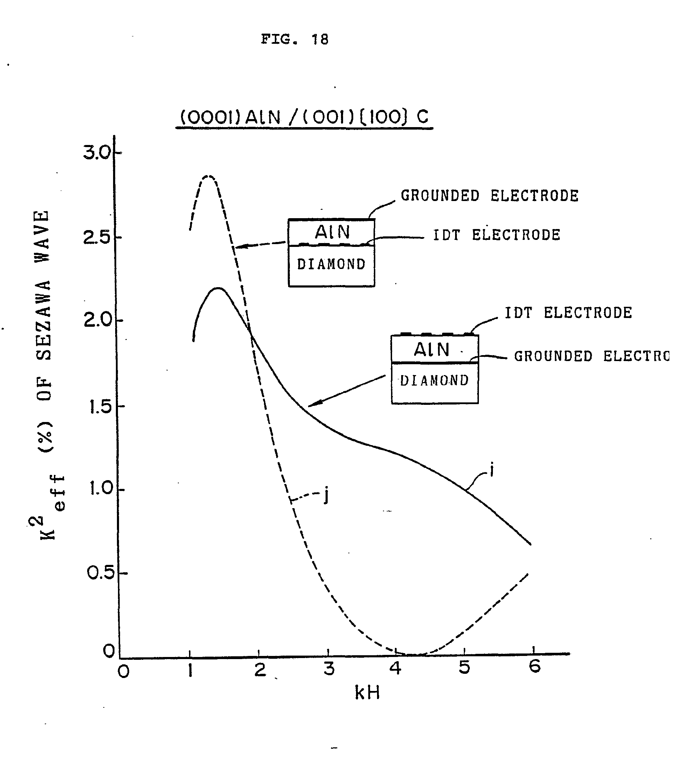

When the effective electromechanical coupling coefficient $K^2_{eff}$ is investigated, four electrode configurations are available. Figs. 17 and 18 illustrates results of analysis of a kH dependency of the effective electromechanical coupling coefficient $K^2_{eff}$ when a Sezawa wave is used for the four electrode configurations.

Referring to Fig. 17, the curve g shows a kH dependency of the effective electromechanical coupling coefficient $K^2_{eff}$ where IDT electrodes are placed on an AlN thin film, while the curve h shows a kH dependency of the electromechanical coupling coefficient $K^2_{eff}$ where IDT electrodes are placed on interface between a diamond crystal thin film and an AlN thin film.

On the other hand, referring to Fig. 18, the curve i shows a kH dependency of the effective electromechanical coupling coefficient $K^2_{eff}$ where IDT electrodes are placed on an AlN thin film and a grounded electrode is disposed on interface between a diamond crystal thin film and the AlN thin film, while the curve j shows a kH dependency of the effective electromechanical coupling coefficient $K^2_{eff}$ where IDT electrodes are placed on interface between a diamond crystal thin film and an AlN thin film and a grounded electrode is placed on the AlN thin film.

From Figs. 17 and 18, where IDT electrodes are provided on interface between a diamond crystal thin film and an AlN thin film (in the case of the curves h and j of the figures), a comparatively high effective electromechanical coupling coefficient $K^2_{eff}$ can be obtained within a limited range of the AlN thin film, but if it is taken into consideration that the technique for making a frequency adjustment is limited only to adjustment of the thickness of the AlN thin film, the frequency adjustment is not easy because the variation of the effective electromechanical coupling coefficient $K^2_{eff}$ with respect to a variation $\Delta H$ of the film

thickness is great and the permissible range of the film thickness H is limited. Accordingly, it is not preferable to provide IDT electrodes on interface between a diamond crystal thin film and an AlN thin film.

On the other hand, where IDT electrodes are provided on an AlN thin film (in the case of the curve g of Fig. 17), the condition of $0.5\% \leq K^2_{eff} \leq 1.26\%$ is obtained over a wide range of $1.1 \leq kH \leq 6.0$, and it can be understood that a comparatively high electromechanical coupling coefficient $K^2_{eff}$ is obtained. Besides, within the range of $2 \leq kH \leq 4$, the variation of the effective electromechanical coupling coefficient $K^2_{eff}$ is low, and the characteristics of the SAW device can be stabilized. Meanwhile, where IDT electrodes are provided on an AlN thin film and a ground electrode is provided on interface between a diamond single-crystal thin film and the AlN thin film (in the case of the curve i of Fig. 18), the condition of $0.7\% \leq K^2_{eff} \leq 2.2\%$ is obtained over a wide range of $1.1 \leq kH \leq 6.0$, and a higher electromechanical coupling coefficient $K^2_{eff}$ can be obtained.

Where IDT electrodes made of a metal such as aluminum are provided on an AlN thin film in this manner, the frequency adjustment is easy. In particular, by forming IDT electrodes with a somewhat greater thickness from aluminum or the like and then shaving the IDT electrodes by chemical or physical etching, the frequency can be adjusted in an increasing direction, and a SAW device of a desired frequency characteristic can be realized. In this instance, since the AlN thin film which constitutes the upper layer is a chemically and physically stable material, there is no possibility that it may be damaged upon etching processing.

Accordingly, in order to readily realize the aimed value ($V_P \geqq 8,000$ m/sec) of the phase velocity $V_P$ of a Sezawa wave and the aimed value ($K^2_{eff} \geqq 0.5$ %) of the effective electromechanical coupling coefficient $K^2_{eff}$ in a two-layer structure composed of a diamond crystal and an AlN thin film or a three-layer structure composed of a Si single-crystal or a GaAs single-crystal, a diamond crystal thin film and an AlN thin film and to facilitate the frequency adjustment, the AlN thin film orientated to the C-axis should be formed on the diamond single-crystal (thin film) by a magnetron sputtering method or the like such that the thickness H of the AlN thin film may satisfy the condition of $1.1 \leqq kH \leqq 6.0$

and IDT electrodes should be formed on the AlN thin film.

Subsequently, an investigation will be made of the thickness D of a diamond crystal thin film necessary to substantially enclose a Sezawa wave in two-layer films of the diamond crystal thin film and an AlN thin film where the diamond crystal thin film is formed on a single-crystal semiconductor substrate. Generally, in order to enclose a Sezawa wave or a Rayleigh wave of a higher degree within a diamond crystal thin film and an AlN thin film, a sufficient thickness D is required for a diamond crystal thin film. However, where a fundamental Sezawa wave mode is used as in the present invention, the thickness D of the diamond crystal thin film can be reduced.

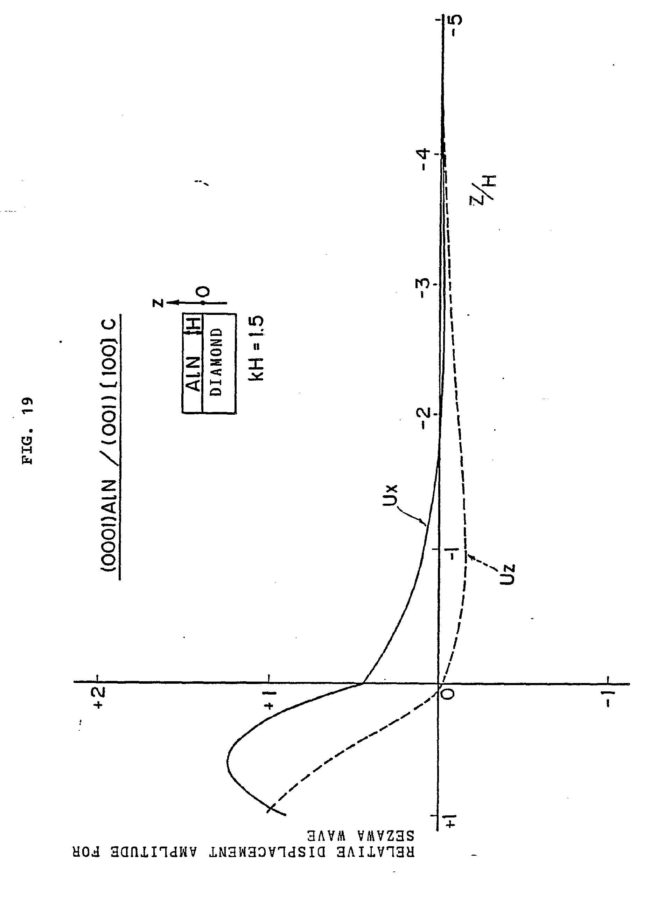

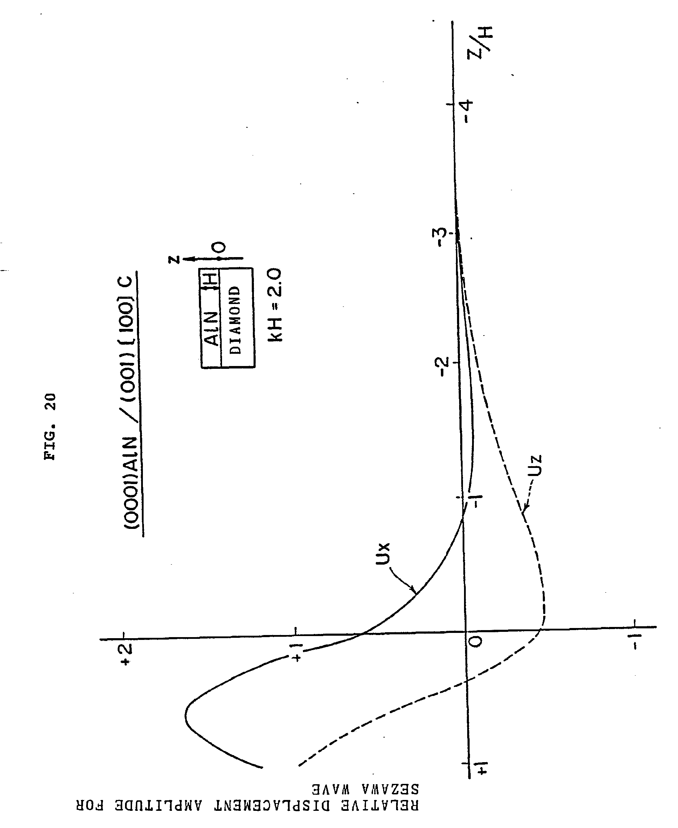

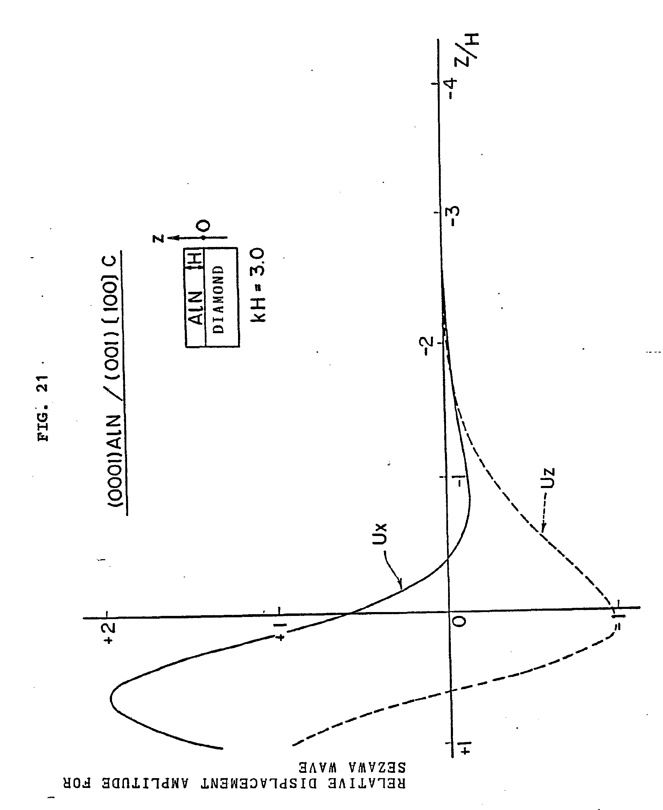

Figs. 19 to 21 are diagrams illustrating results of analysis of a depth (Z direction) dependency of the relative amplitude of displacement for a Sezawa wave when kH is changed to 1.5, 2.0 and 3.0. In those figures, the axis of abscissa represents a distance in the Z-axis direction from an interface between a diamond crystal thin film and an AlN thin film with a value $Z/H$ obtained by dividing the distance by a thickness H of the AlN thin film to normalize the same. The solid line characteristic curve $U_Z$ indicates a relative amplitude value of a Z-axis component, while the broken line characteristic curve $U_X$ indicates a relative amplitude value of an X-axis component. It is to be noted that $U_Z$ and $U_X$ represent relative values when the absolute value of a maximum amplitude of the Z-axis component is represented by 1. From the figures, it can be apparently seen that as kH increases, that is, as the thickness H of an AlN thin film, if it is assumed that the wave length determined by the electrode finger width d is fixed, increases, the attenuance of a Sezawa increases and the energy concentrates on a location proximate a surface of the AlN thin film. Accordingly, the relationship between the thickness D of the diamond crystal thin film and the thickness H of the AlN thin film necessary to enclose a Sezawa wave within the two-layer films of the diamond crystal thin film and the AlN thin film should satisfactorily be $D \geq 5H$.

From the results of analysis described above, by constituting a substrate construction as a three-layer structure composed of a single-crystal semiconductor substrate of a Si single-crystal, a GaAs single-crystal or the like, a diamond crystal thin film and an AlN thin film and providing IDT electrodes on the AlN thin film

such that the thickness D of the diamond crystal thin film and the thickness H of the AlN thin film may satisfy the conditions of $D \geq 5H$ and $1.1 \leq kH \leq 6.0$, a SAW device can be realized which satisfies the conditions of $V_P \geq 8,000$ m/sec and $K^2_{eff} \geq 0.5$ %. In this instance, since the IDT electrodes are provided in an exposed relationship on the AlN thin film, the frequency adjustment can be made readily by adjusting the thickness of the IDT electrodes after formation of the IDT electrodes.

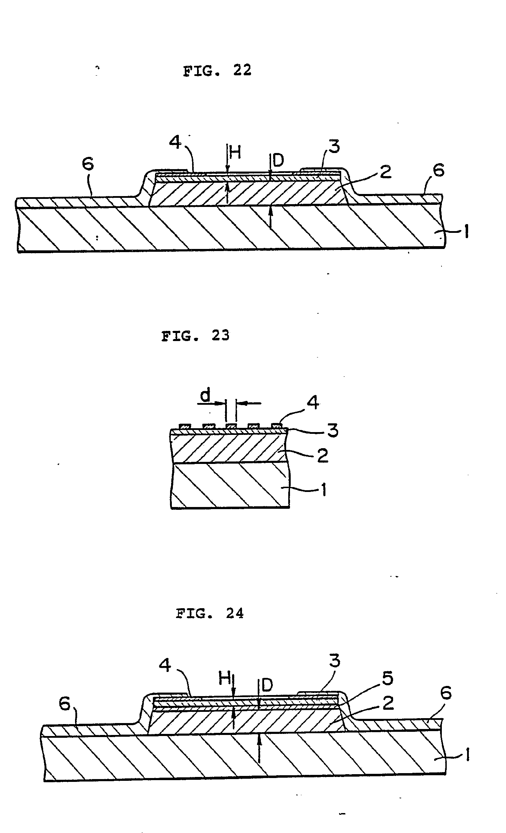

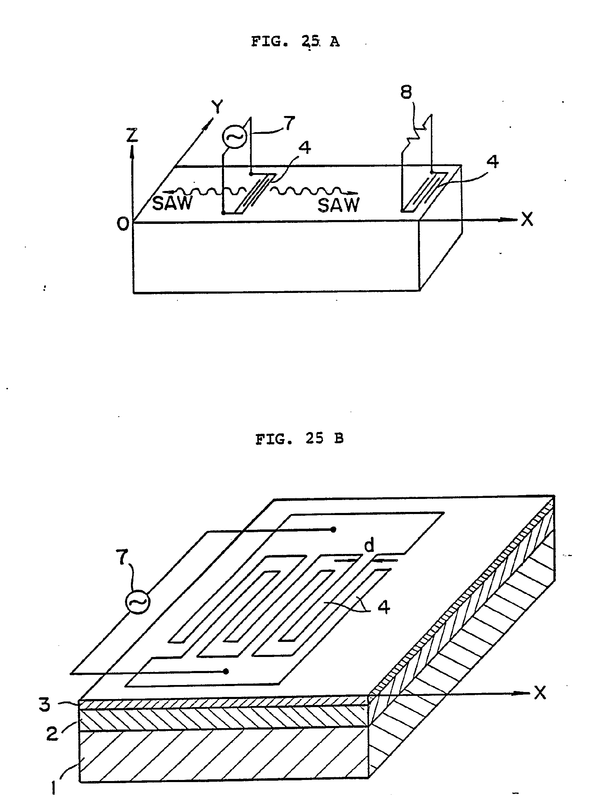

Figs. 22 and 23 are views schematically showing a sectional construction of a SAW device wherein IDT electrodes are provided on an AlN thin film as a preferred embodiment of the first basic form of the present invention. Fig. 24 is a view schematically showing a sectional construction of a SAW device wherein IDT electrodes are provided on an AlN thin film and a grounded electrode is provided on an interface between a diamond crystal thin film and the AlN thin film. In those figures, reference 1 denotes a single-crystal semiconductor substrate formed from a Si single-crystal, a GaAs single-crystal or the like, 2 a diamond crystal thin film, 3 an AlN thin film orientated to the C-axis, and 4 an IDT electrode. In the SAW device shown in Fig. 24, a ground electrode 5 is formed on an interface between the diamond crystal thin film 2 and the AlN thin film 3. In those embodiments, the thickness D of the diamond crystal thin film 2 and the thickness H of the AlN thin film 3 are set, when a narrowband timing tank filter or bandpass filter for use in a microwave region is to be provided, such that they may satisfy the conditions of $3.5 \leq kH \leq 5.0$ and $D \geq 4H$, respectively, but when a wideband voltage-controlled oscillator or a wide bandpass filter is to be provided, such that they may satisfy the conditions of $1.1 \leq kH \leq 6.0$ and $D \geq 5H$, respectively.

As can be seen from Figs. 22 to 24, since each of the SAW devices has the single-crystal semiconductor substrate 1 formed from a Si single-crystal, a GaAs single-crystal or the like, it is possible to use the single-crystal semiconductor substrate 1 as a common substrate and form a peripheral LSI or LSIs (not shown) and the SAW device in an integrated relationship on the common substrate, and besides, electric connection to the LSI or LSIs can be made readily by means of a conductive thin film or films 6 of Al, Au or the like. Accordingly, the mass production is facilitated and the reliability is improved comparing with the prior art wherein a SAW device is formed in a separate relationship from an LSI or LSIs and connected to the latter by means of a bonding wire or the like.

Fig. 25A is a schematic view showing an example of application of the SAW device shown in Figs. 22 and 23, and Fig. 25B is a schematic sectional perspective view taken along a location near an IDT electrode of the SAW device shown in Fig. 25A. Two sets of IDT electrodes 4 are formed at opposing locations, and SAWs are generated in response to a signal from an input side high frequency circuit 7 by the electrodes 4 of one set, while the thus propagated SAWs are converted by the other IDT electrodes 4 again into an electric signal which is applied to an output side load circuit 8. It is to be noted that such structure is suitable for a filter circuit such as a timing tank filter or a bandpass filter or for a delay line circuit. Meanwhile, in order to realize a resonator, though not shown, means for reflecting SAWs should be provided on the opposite sides of a single IDT electrode with respect to the SAW propagating direction. In this instance, a reflecting grating is more suitable as the reflecting means than a single reflecting plane in prevention of a loss in mode conversion.

It it to be noted that, as apparent from the analyses described above, in the first basic form of the present invention, a SAW device may be provided not necessarily by crystal growth of a diamond crystal thin film on a substrate such as a single-crystal semiconductor substrate but also in a two-layer structure composed of a natural or industrially produced diamond crystal and an AlN thin film.

According to the first basic form of the present invention described above, where, for example, a third Rayleigh wave is used, a SAW filter for 7 to 10 GHz can be realized when the photo-lithography employing far-ultraviolet radiation as a light source is used, and a SAW filter for 10 to 20 GHz can be realized when an electron beam is used. However, the first basic form has a drawback in production that, when an AlN thin film is evaporated on a synthetic diamond polycrystal thin film or a synthetic diamond single-crystal by a PVD method or a CVD method, it is difficult to assure crystal growth of the C-axis orientation AlN thin film having a good characteristic.

Thus, the second basic form of the present invention makes use of the rule of thumb of Bravais that the C-axis is oriented, with respect to an amorphous substrate, in a direction perpendicular to the substrate. For example, a zinc oxide (ZnO) film or an AlN piezoelectric thin film can be C-axis oriented readily on a pyrex glass or fused quartz.

Thus, formation of an AlN thin film is facilitated by depositing a $SiO_2$ thin film in the form of an amorphous film on a diamond crystal by a PVD method, CVD method or the like and C-axis orienting the AlN thin film on the $SiO_2$ thin film.

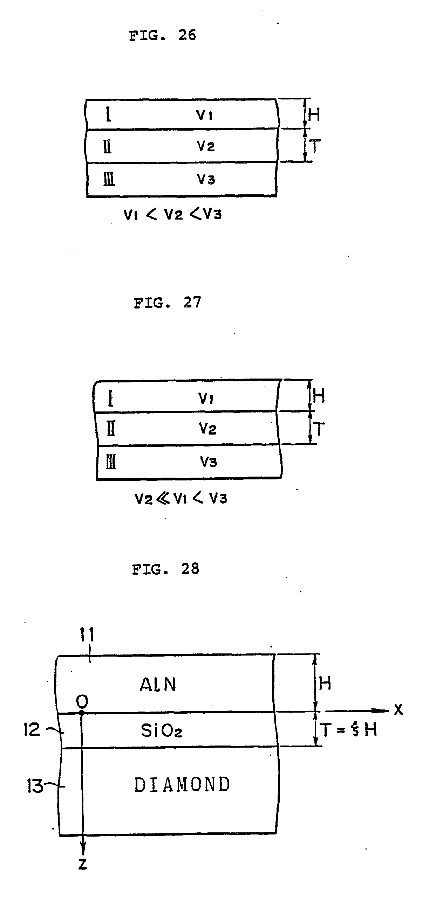

However, the acoustic velocity of a bulk wave which propagates in a $SiO_2$ thin film is very low at about one half the acoustic velocity of a bulk wave which propagates in an AlN thin film. Generally, in the case of a SAW device having a three-layer structure, when the propagating velocities $v_1$, $v_2$ and $v_3$ of a film thickness shear wave in the first layer I, second layer II and third layer III, respectively, from above in Fig. 26 have the relationship of $v_1 < v_2 < v_3$, SAWs of a fundamental wave mode and higher degree wave modes of a Rayleigh wave are allowed to propagate in the SAW device. However, when the propagating velocities $v_1$, $v_2$ and $v_3$ of a film thickness shear wave in the first layer I, second layer II and third layer III, respectively, have the relationship of $v_2 << v_1 < v_3$ as shown in

Fig. 27, only a fundamental Rayleigh wave mode is allowed to propagate only in the first layer I and the second layer II.

Thus, if the thickness T of the $SiO_2$ thin film which is the second layer can be controlled within a predetermined range with respect to the thickness H of the AlN thin film which is the first layer, then it can be considered that a third Rayleigh wave mode which has an ultra high velocity greater than or equal to the acoustic velocity of 10,000 m/sec is allowed to propagate. Standing on such a point of view, an investigation will be made of a suitable thickness of a $SiO_2$ thin film which can be produced actually and in which a third Rayleigh wave mode can be enclosed and propagate in three layers.

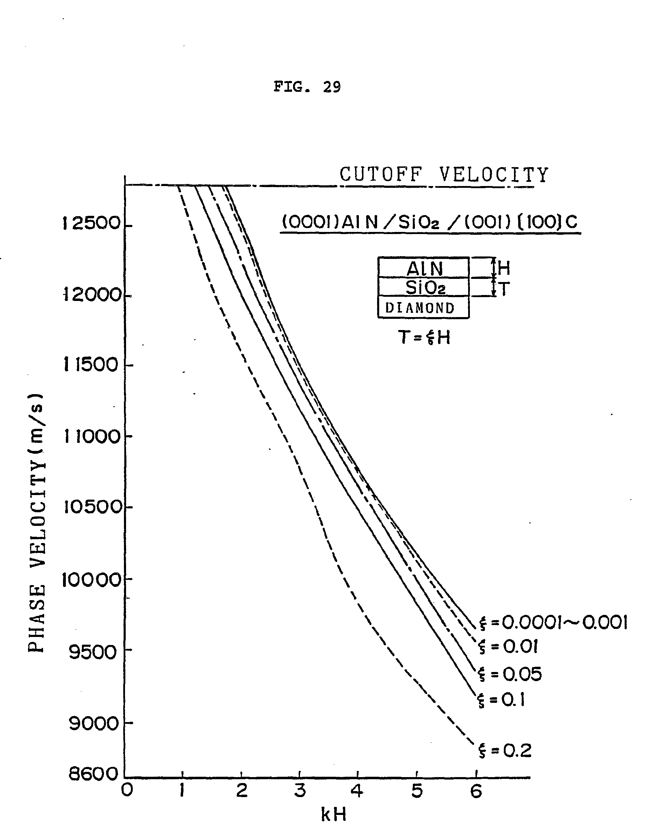

Fig. 28 is a view schematically showing a SAW device of the second basic form of the present invention. The SAW device includes, from above, an AlN thin film 11 (with a thickness H), a $SiO_2$ thin film 12 (with a thickness $T = \gtrless H$) and a diamond crystal thin film 13 formed from a synthetic diamond polycrystal or a synthetic diamond single-crystal. The axes of coordinates include an X-axis parallel to the thin films, a Z-axis perpendicular to the thin films, and a Y-axis perpendicular to the plane of Fig. 28. Here, the cut plane of the diamond crystal 13 is a (001) while the AlN thin film 11 is a film with the C-axis oriented in the Z-axis direction, that is, a plane (0001) so that a SAW may propagate in the X-axis direction.

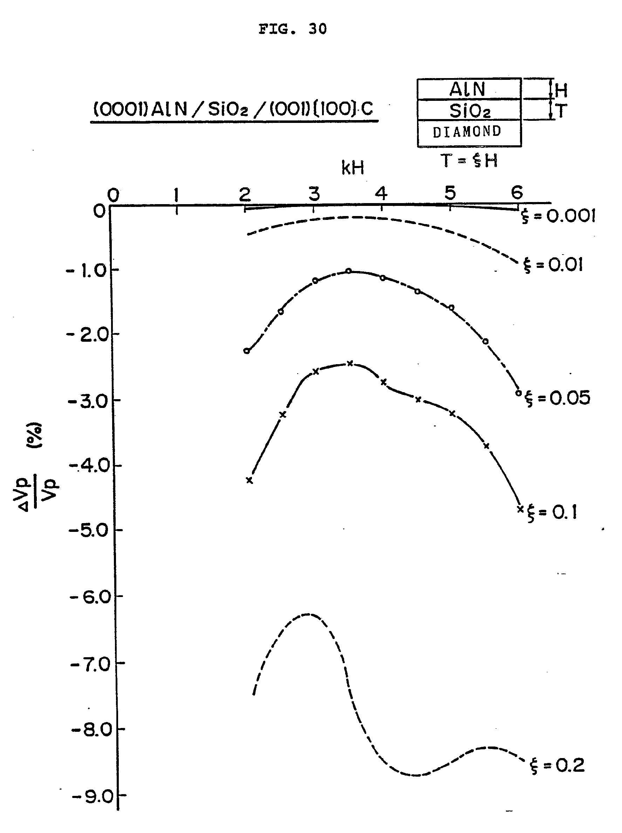

Fig. 29 is a view showing the SAW velocity dispersion characteristics for a third Rayleigh wave mode in the structure shown in Fig. 28, that is, a dependency of the phase velocity $V_p$ (m/sec) on the product kH of the thickness H of the AlN thin film and the wave number k of the SAW. Meanwhile, Fig. 30 is a view showing a rate of change $\Delta V_p/V_p$ of the phase velocity $V_p$ with respect to a parameter $\xi$ of the $SiO_2$ film. Here, the phase velocity (acoustic velocity) at $\xi = 0$ is adopted as a standard. The following facts become clear from Figs. 29 and 30.

(1)  At $\xi = 0.0001$ to $0.001$, the phase velocity of a third Rayleigh wave is almost invariable.

(2)  There is a local maximum point of the rate of change $\Delta V_p/V_p$ of the phase velocity $V_p$ at a position of kH = 3.5, and as $\xi$ increases, the local maximum point is shifted in the direction in which kH decreases, that is, in the direction in which the wave length $\lambda$ becomes $\lambda \gg H$.

(3) In the case of kH = 3.5, the rate of change $\Delta V_p/V_p$ (rate of decrease) of the phase velocity $V_p$ is -0.2 % at $\frac{\ell}{\zeta}$ = 0.01, -1.0 % at $\frac{\ell}{\zeta}$ = 0.05, -2.5 % at $\frac{\ell}{\zeta}$ = 0.1, and -7.7 % at $\frac{\ell}{\zeta}$ = 0.2.

From those facts, it can be understood that the condition of $\frac{\ell}{\zeta}$ > 0.1 is not preferable for utilization because the phase velocity is significantly low and the region within which the phase velocity is higher than or equal to 10,000 m/sec comes within a limited range of kH ≤ 3.7. The finger width d of IDT electrodes which can be realized by photo-lithography based on far-ultraviolet exposure at present is d ≥ 0.3 $\mu$m and the finger width d of IDT electrodes and the SAW phase velocity have a relationship of d = (1/4) • $V_p/\nu$ ($\nu$ is a frequency). Accordingly, while the phase velocity of a SAW relates to whether a SAW device for the 1 to 10 GHz can be realized using photo-lithography based on far-ultraviolet exposure, when a device of the second basic form of the present invention is to be applied as the SAW device, it is necessary to further examine an influence of a $SiO_2$ thin film upon the effective electromechanical coupling coefficient $K^2_{eff}$ which indicates a degree of the piezoelectricity.

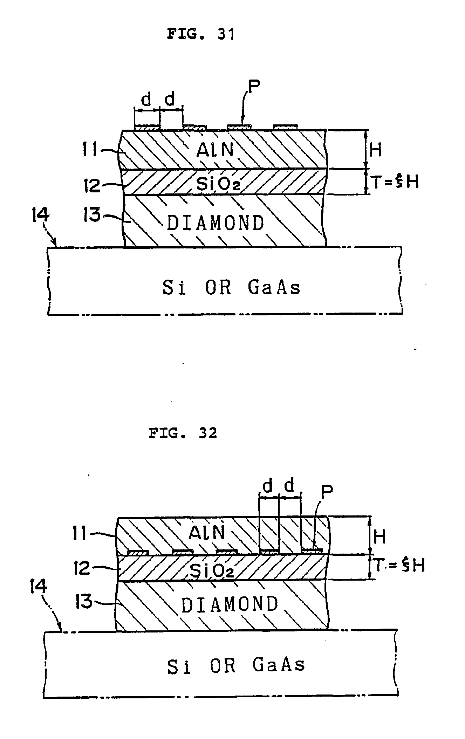

IDT electrodes can be located in two various manners with respect to the three-layer structure of Fig. 28. Fig. 31 shows a desirable embodiment of the second basic form of the present invention wherein IDT electrodes P of aluminum (Al) are formed on an AlN thin film 11 by deposition, while Fig. 32 shows another desirable embodiment of the second basic form of the present invention wherein IDT electrodes P of Al are provided on an interface between an AlN thin film 11 and a $SiO_2$ thin film 12.

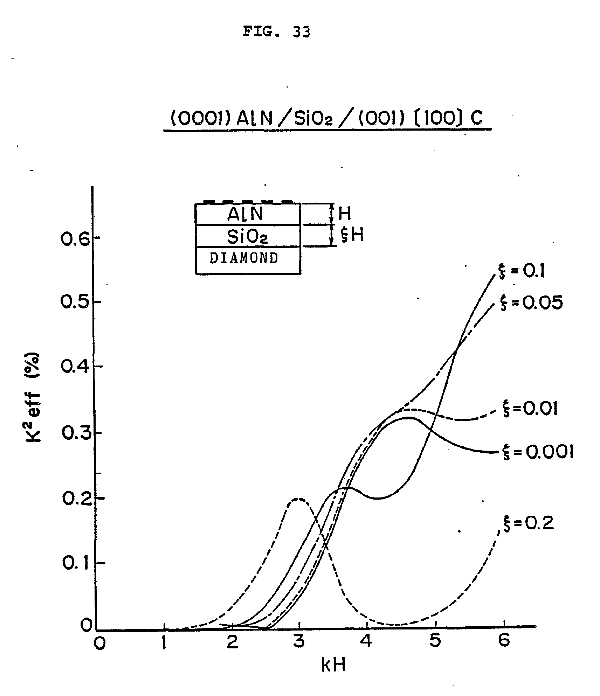

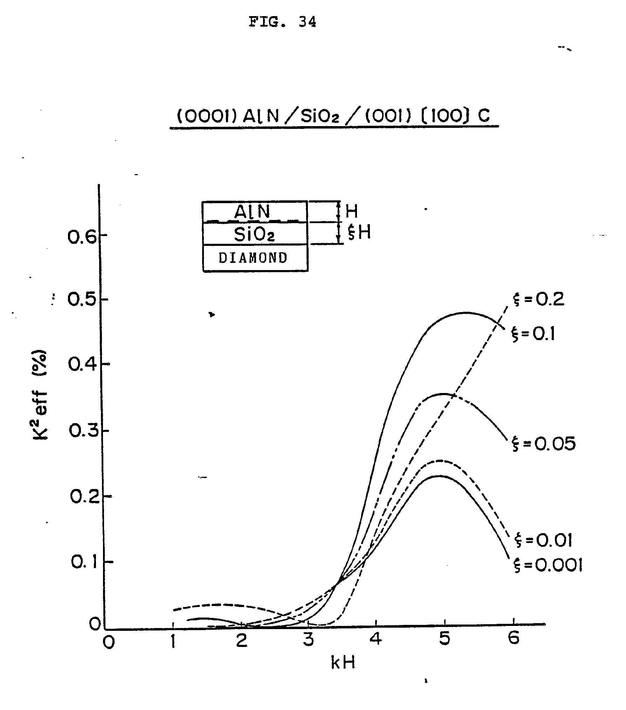

Fig. 33 is a diagram showing a kH dependency of the effective electromechanical coupling coefficient $K^2_{eff}$ in the case of the configuration of Fig. 31, and Fig. 34 is a diagram showing a kH dependency of the electromechanical coupling coefficient $K^2_{eff}$ in the case of the configuration of Fig. 32. From Fig. 33, it can be seen that, at $\lessgtr \leq 0.001$, $K^2_{eff}$ presents little difference from that in the case of $\lessgtr = 0$, but at least within the range of $3.2 \leq kH \leq 4.7$, $k^2_{eff}$ increases as $\lessgtr$ increases, and after $\lessgtr = 0.05$ is exceeded, $K^2_{eff}$ decreases suddenly. Accordingly, since $K^2_{eff}$ increases if the thickness of the $SiO_2$ thin film 12 is controlled within a limited range, it can be understood that it is advantageous to interpose the $SiO_2$ thin film 12 as an intermediate layer between the AlN thin film 11 and a diamond crystal thin film 13. However, since $K^2_{eff}$ decreases suddenly within the range of $\frac{T}{H} > 0.1$, control within the range of $\frac{T}{H} > 0.1$ is not preferable.

On the other hand, it can be seen also from Fig. 34 that $K^2_{eff}$ increases as $\frac{T}{H}$ increases within the range of $3.7 \leq kH \leq 4.7$. Accordingly, it can be understood that it is advantageous to interpose the $SiO_2$ thin film 12 between the AlN thin film 11 and a diamond crystal thin film 13. However, since $K^2_{eff}$ decreases within the range of $\frac{T}{H} > 0.1$, control within the range of $\frac{T}{H} > 0.1$ is not preferable.

As a result of the foregoing investigations of the two points of the dispersion characteristics of the SAW phase velocity and the effective electromechanical coupling coefficient, it has become apparent that a SAW device having the characteristics of $V_p \geq 10,000$ m/sec and $K^2_{eff} \geq 0.1\ \%$ can be realized if the following conditions are satisfied.

(1) The film thickness T of the $SiO_2$ is controlled within 1/100 to 1/10 of the thickness H of the AlN thin film $(0.01 \leq \frac{T}{H} \leq 0.1)$.

(2) Where IDT electrodes are provided on the AlN thin film, the thickness H of the AlN thin film is controlled so as to meet the condition of

$3.2 \leqq kH \leqq 4.7$.

(3) Where IDT electrodes are provided between the AlN thin film and the $SiO_2$ thin film, the thickness H of the AlN thin film is controlled so as to meet the condition of $3.7 \leqq kH \leqq 4.7$.

For example, a SAW device for 10 GHz having the construction of Fig. 31 can be realized readily by two sets of values listed in Table 1 below.

Table 1

| $\frac{d}{\lambda}$ | 0.1 | 0.05 |
|---|---|---|
| kH | 3.5 | 3.5 |
| $K^2_{eff}$ (%) | 0.21 | 0.18 |
| $V_P$ (m/sec) | 10,800 | 11,000 |
| $\lambda$ ($\mu$m) | 1.08 | 1.10 |
| d ($\mu$m) | 0.27 | 0.275 |
| H ($\overset{o}{A}$) | 6,000 | 6,130 |
| T ($\overset{o}{A}$) | 600 | 300 |

On the other hand, a SAW device for 5 GHz having the construction of Fig. 31 can be realized readily by two sets of values listed in Table 2 below.

Table 2

| $\frac{t}{\lambda}$ | 0.1 | 0.05 |
|---|---|---|
| kH | 3.5 | 3.5 |
| $K^2_{eff}$ (%) | 0.21 | 0.18 |
| $V_P$ (m/sec) | 10,800 | 11,000 |
| $\lambda$ ($\mu$m) | 2.16 | 2.20 |
| d ($\mu$m) | 0.54 | 0.55 |
| H ($\overset{o}{A}$) | 12,000 | 12,200 |
| T ($\overset{o}{A}$) | 1,200 | 610 |

It is to be noted that, in constructing a SAW device according to the second basic form of the present invention, it is preferable to form, as shown in Figs. 31 and 32, a three-layer structure composed of a diamond crystal thin film 13, a $SiO_2$ thin film 12 and an AlN thin film 11 on a semiconductor substrate 14 of Si, GaAs or the like similarly as in the embodiments of the first basic form of the present invention.

INDUSTRIAL APPLICABILITY

As described so far, a SAW device of the present invention is suitable to realize a narrowband timing tank filter or bandpass filter for use in a microwave region of several GHz to 20 GHz or a wideband voltage-controlled oscillator or a wide bandpass filter which is used in a wide frequency range from the VHF-band to the UHF-band.

CLAIMS

1.  A surface acoustic wave device, characterized in that

it comprises a diamond crystal and an aluminum nitride thin film (3) formed on said diamond crystal, and

surface acoustic waves propagate on said diamond crystal and said aluminum nitride thin film (3).

2.  A surface acoustic wave device as set forth in claim 1, characterized in that interdigital transducer electrodes (4) are formed on said aluminum nitride thin film (3).

3.  A surface acoustic wave device as set forth in claim 2, characterized in that the thickness H of said aluminum nitride thin film (3) has a value which satisfies the expression

$$3.5 \leq kH \leq 5.0$$

where k is a wave number, and among surface acoustic waves which propagate in said diamond crystal and said aluminum nitride thin film (3), a third Rayleigh wave is utilized.

4.  A surface acoustic wave device as set forth in claim 2, characterized in that the thickness H of said aluminum nitride thin film (3) has a value which

satisfies the expression

$$1.1 \leqq kH \leqq 6.0$$

where k is a wave number, and among surface acoustic waves which propagate in said diamond crystal and said aluminum nitride thin film (3), a Sezawa wave is utilized.

5. A surface acoustic wave device as set forth in claim 1, characterized in that said diamond crystal is a diamond crystal thin film (2) formed on a single-crystal semiconductor substrate (1).

6. A surface acoustic wave device as set forth in claim 5, characterized in that interdigital transducer electrodes (4) are formed on said aluminum nitride thin film (3).

7. A surface acoustic wave device as set forth in claim 6, characterized in that the thickness H of said aluminum nitride thin film (3) has a value which satisfies the expression

$$3.5 \leqq kH \leqq 5.0$$

where k is a wave number while the thickness D of said diamond crystal thin film (2) and the thickness H of said aluminum nitride thin film (3) have the relationship of

$$D \geqq 4H$$

and among surface acoustic waves which propagate in said diamond crystal thin film (2) and said aluminum nitride thin film (3), a third Rayleigh wave is utilized.

8. A surface acoustic wave device as set forth in claim 6, characterized in that the thickness H of said aluminum nitride thin film (3) has a value which satisfies the expression

$$1.1 \leqq kH \leqq 6.0$$

where k is a wave number while the thickness D of said diamond crystal thin film (2) and the thickness H of said aluminum nitride thin film (3) have the relationship of

$$D \geqq 5H$$

and among surface acoustic waves which propagate in said diamond crystal thin film (2) and said aluminum nitride thin film (3), a Sezawa wave is utilized.

9. A surface acoustic wave device, characterized in that

it comprises a diamond crystal, a silicon dioxide thin film (12) formed on said diamond crystal, and an aluminum nitride thin film (11) formed on said silicon dioxide thin film (12), and

surface acoustic waves propagate on a three-layer structure which is composed of said diamond crystal, silicon dioxide thin film (12) and aluminum nitride thin film (11).

10. A surface acoustic wave device as set forth in claim 9, characterized in that the thickness T of said silicon dioxide thin film (12) has a value which has the relationship of

$$0.01H \leq T \leq 0.1H$$

to the thickness H of said aluminum nitride thin film (11).

11. A surface acoustic wave device as set forth in claim 10, characterized in that interdigital transducer electrodes (P) are formed on said aluminum nitride thin film (11) which has a thickness H which satisfies the expression

$$3.2 \leq kH \leq 4.7$$

where k is a wave number, and among surface acoustic waves which propagate in said three-layer structure, a third Rayleigh wave is utilized.

12. A surface acoustic wave device as set forth in claim 10, characterized in that interdigital transducer electrodes (P) are formed on interface between said aluminum nitride thin film (11) and said silicon dioxide thin film (12) while said aluminum nitride thin film (11) has a thickness H which satisfies the expression of

$$3.7 \leqq kH \leqq 4.7$$

where k is a wave number, and among surface acoustic waves which propagate in said three-layer structure, a third Rayleigh wave is utilized.

13.  A surface acoustic wave device as set forth in claim 9, characterized in that said diamond crystal is a diamond crystal thin film (13) formed on a single-crystal semiconductor substrate (14).

## FIG. 1

Z
H
PROPAGATING DIRECTION
ZnO FILM
O
X
Si SINGLE-CRYSTAL
$-\infty$

## FIG. 2

FIG. 3

(0001) AlN / (001) [100] Si

PHASE VELOCITY(m/s)

RAYLEIGH WAVE

AlN
Si

AlN
Si

kH

FIG. 4

(0001) AlN / (001) [100] GaAs

FIG. 5

PROPAGATING DIRECTION

Z

H

(I) THIN FILM

O X

(II) THIN FILM

(III) Si OR GaAs CRYSTAL

-∞

FIG. 6

Z

H

H AlN FILM

O X

D DIAMOND FILM

-D Si OR GaAs CRYSTAL

-∞

FIG. 7 A          FIG. 7 B

Z

H

AlN FILM

O DIAMOND FILM

-D

Si OR GaAs

D ≪ H

Z

H

AlN FILM

O

DIAMOND FILM

-D

Si OR GaAs

D ≫ H

FIG. 8

| ALN |
|---|
| DIAMOND |

(0001) ALN / (001) [100] C

FIG. 8

FIG. 9

(OOOI) AlN / (OOI) [IOO] C

FIG. 10

(OOOI) AlN / (OOI) (IOO) C

FIG. 11

FIG. 12

FIG. 13

(OOOI) ALN / (OOI) (IOO) C

$K^2_{eff}$ (%) OF THIRD RAYLEIGH WAVE

IDT ELECTRODE

GROUNDED ELECTRODE

ALN

DIAMOND

GROUNDED ELECTRODE

IDT ELECTRODE

ALN

DIAMOND

e

f

kH

FIG. 14

(OOOI)AlN /(OOI)(IOO) C

## FIG. 15

### (0001) AlN / (001)(100)C

RELATIVE DISPLACEMENT AMPLITUDE (Uₓ)
(X-AXIS COMPONENT) FOR THIRD RAYLEIGH WAVE

kH = 6
kH = 4
kH = 3
kH = 1.8

EP 0 363 495 A1

FIG. 16

(OOOI) AlN / (OOI) [IOO] C

FIG. 17

## (OOOI)AlN /(OOI)[IOO] C

FIG. 18

(OOOI) AlN / (OOI) [IOO] C

FIG. 19

EP 0 363 495 A1

FIG. 20

(OOOI)AlN / (OOI) [IOO] C

RELATIVE DISPLACEMENT AMPLITUDE FOR
SEZAWA WAVE

kH = 2.0

Ux

Uz

EP 0 363 495 A1

FIG. 21

(OOOI)AlN / (OOI) [IOO] C

FIG. 22

FIG. 23

FIG. 24

FIG. 25 A

FIG. 25 B

## FIG. 26

$$V_1 < V_2 < V_3$$

## FIG. 27

$$V_2 \ll V_1 < V_3$$

## FIG. 28

FIG. 29

CUTOFF VELOCITY

(000l)AlN／SiO₂／(00l)〔l00〕C

| AlN |
|---|
| SiO₂ |
| DIAMOND |

$T = \xi H$

$\xi = 0.0001 \sim 0.001$

$\xi = 0.01$

$\xi = 0.05$

$\xi = 0.1$

$\xi = 0.2$

FIG. 30

FIG. 31

FIG. 32

FIG. 33

(OOOl) AlN / SiO₂ / (OOl) [lOO] C

FIG. 34

(OOOI) AlN / SiO₂ / (OOl) [IOO] C

# INTERNATIONAL SEARCH REPORT

International Application No PCT/JP89/00283

## I. CLASSIFICATION OF SUBJECT MATTER (if several classification symbols apply, indicate all) 6

According to International Patent Classification (IPC) or to both National Classification and IPC

Int. Cl$^4$  H03H9/25, H03H9/145

## II. FIELDS SEARCHED

Minimum Documentation Searched :

| Classification System | Classification Symbols |
|---|---|
| IPC | H03H9/25, H03H9/145 |

Documentation Searched other than Minimum Documentation
to the Extent that such Documents are Included in the Fields Searched 6

| | |
|---|---|
| Jitsuyo Shinan Koho | 1977 - 1989 |
| Kokai Jitsuyo Shinan Koho | 1974 - 1989 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| P | JP, A, 1-62911 (Sumitomo Electric Industries, Ltd.) 9 March 1989 (09. 03. 89) Page 2, lower left column, lines 3 to 8, page 3, upper right column, line 18 to lower right column, line 1 (Family: none) | 1, 2 |
| P | JP, A, 1-20714 (Murata Seisakusho Kabushiki Kaisha) 24 January 1989 (24. 01. 89) Page 2, lower right column, lines 3 to 14 (Family: none) | 1, 2 |
| A | JP, A, 57-97214 (Matsushita Electric Ind. Co., Ltd.) 16 June 1982 (16. 06. 82) Page 3, upper right column, lines 10 to 16 & US, A, 4501987 | 3, 7, 11-12 |
| A | JP, A, 60-169210 (Murata Seisakusho Kabushiki Kaisha) | 4, 8 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| June 8, 1989 (08. 06. 89) | June 26, 1989 (26. 06. 89) |

| International Searching Authority | Signature of Authorized Officer |
|---|---|
| Japanese Patent Office | |

Form PCT/ISA/210 (second sheet) (January 1985)

## FURTHER INFORMATION CONTINUED FROM THE SECOND SHEET

| | | |
|---|---|---|
| | 2 September 1985 (02. 09. 85)<br>Page 2, upper left column, lines 7 to 9<br>(Family: none) | |
| A | JP, A, 58-156216 (Mikoshi Norio and<br>one other)<br>17 September 1983 (17. 09. 83)<br>Figs. 2 to 3, 5 to 6, 8 to 9<br>& DE, A1, 3037130 & GB, A, 2060303 &<br>DE, A1, 3308365 & FR, A1, 2523382 &<br>JP, A, 58-156215 & JP, A, 58-156217<br>& GB, A, 2120036 & GB, A, 2120037<br>& US, A, 4447895 & GB, B, 2060303 & | 3, 4, 7, 8 |

**V.☐ OBSERVATIONS WHERE CERTAIN CLAIMS WERE FOUND UNSEARCHABLE [1]**

This international search report has not been established in respect of certain claims under Article 17(2) (a) for the following reasons:

1.☐ Claim numbers ............, because they relate to subject matter not required to be searched by this Authority, namely:

2.☐ Claim numbers ............, because they relate to parts of the international application that do not comply with the prescribed requirements to such an extent that no meaningful international search can be carried out, specifically:

3.☐ Claim numbers ............, because they are dependent claims and are not drafted in accordance with the second and third sentences of PCT Rule 6.4(a).

**VI.☐ OBSERVATIONS WHERE UNITY OF INVENTION IS LACKING [2]**

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)

| FURTHER INFORMATION CONTINUED FROM THE SECOND SHEET | |
|---|---|
| GB, B, 2120036 & DE, C2, 3037130 & US, A, 4509148 & US, A, 4511816 | |
| A    JP, A, 59-64908 (Mikoshi Norio and one other) 13 April 1984 (13. 04. 84) Figs. 5 to 6 & DE, A1, 3336281 & FR, A1, 2534089 & GB, A, 2130452 & US, A, 4516049 | 9-12 |

**V.☐ OBSERVATIONS WHERE CERTAIN CLAIMS WERE FOUND UNSEARCHABLE ¹**

This international search report has not been established in respect of certain claims under Article 17(2) (a) for the following reasons:

1.☐ Claim numbers ............, because they relate to subject matter not required to be searched by this Authority, namely:

2.☐ Claim numbers ............, because they relate to parts of the international application that do not comply with the prescribed requirements to such an extent that no meaningful international search can be carried out, specifically:

3.☐ Claim numbers ............, because they are dependent claims and are not drafted in accordance with the second and third sentences of PCT Rule 6.4(a).

**VI.☐ OBSERVATIONS WHERE UNITY OF INVENTION IS LACKING ²**

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.